# EUROPEAN PATENT APPLICATION

(11) **EP 1 708 249 A2**
(43) Date of publication of application: **04.10.2006**
(21) Application number: 06111436.9
(22) Date of filing: 21.03.2006
(51) Int. Cl.: H01L 21/00

(54) **Cleaning device and cleaning method**

(30) Priority: 31.03.2005 JP 2005104614; 26.07.2005 JP 2005216217
(71) Applicant: KAIJO CORPORATION, Tokyo (JP)
(72) Inventor: Sawaki, Akira, Tokyo (JP); Kouno, Michihisa, Tokyo (JP)
(74) Representative: Betten & Resch

(57) **Abstract**

The invention provides a cleaning device for cleaning or rinsing a wafer disposed in a cleaning bath by cleaning fluid in the cleaning bath including a front wall that configures the cleaning bath by being in abutment with a device body and is formed with an opening corresponding to a contour of the target object; a wafer holding device being capable of holding a rear face of the target object carried into the inner side of the one side wall through the opening from the outside of the one side wall and holding the target object in a vertically upright position; and a pins provided on a circumference of the opening on an inner surface of the one side wall for defining a clearance between the wafer and the circumference of the opening by being in contact with the rear face of the target object.

## Description

### BACKGROUND OF THE INVENTION

### 1. Field of the Invention

The present invention relates to a cleaning device and a cleaning method for cleaning a target object in a cleaning bath and a cleaning method therefor and, more specifically, to a cleaning device and a cleaning method for cleaning a font surface and/or a rear face of a semiconductor substrate such as a wafer simultaneously one-by-one.

### 2. Description of the Related Art

In the semiconductor manufacturing process, cleaning devices that clean, rinse and dry semiconductor substrates such as wafers one-by-one are generally a spin type as disclosed in JP-A-2000-21840. As shown in Fig. 24, such a cleaning device 100 is provided with a wafer receiving base 103 in a cylindrical chamber 102 for holding an end surface or the like of a wafer 101 using a chuck or the like, and the wafer receiving base is supported by a revolving shaft 104. The revolving shaft 104 is connected to a motor (not shown), and is provided so that the wafer 101 held by the wafer receiving base 103 is rotated by driving the motor.

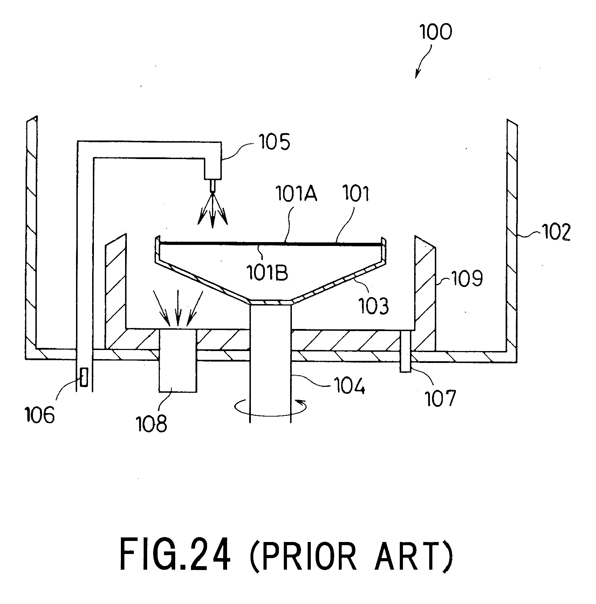

A supply nozzle 105 is provided above the wafer receiving base 103, and cleaning liquid such as organic solvent, pure water for rinsing, drying fluid such as nitrogen gas are supplied from the supply nozzle 105 to the wafer 101 on the wafer receiving base 103 in sequence, where the wafer 101 is cleaned, rinsed, and dried. The supply nozzle 105 is provided with a temperature sensor 106 at a proximal portion thereof for measuring the temperatures of cleaning liquid, pure water and drying fluid which are introduced into the supply nozzle 105. Reference numeral 107in Fig. 24 designates a drain port and reference numeral 108 designates an air discharge outlet.

In JP-A-5-13397, a dip-type cleaning device in which cleaning liquid is filled in a cleaning bath, a peace of wafer is dipped into the cleaning liquid, and cleaning front and rear faces of the wafer simultaneously using ultrasonic vibrations is proposed.

However, With a spin type cleaning device 100 shown in Fig. 24, cleaning liquid poured on a surface 101A of the wafer 101 for cleaning may run along the surface thereof to a rear face 101B, and since the end surface or the like of the wafer 101 is held by the chuck or the like on the wafer receiving base 103, it is difficult to clean the end surface or the like which is in contact with the chuck or the like.

With the cleaning device 100, since the wafer 101 is placed horizontally, the entire space for installing the washing device 100 is increased. In addition, since the cleaning device 100 is provided with the wafer receiving base 103 and the revolving shaft 104 as the rotary mechanism, the number of components increases, and adjustment of the rotary mechanism takes a lot of trouble.

With the cleaning device 100, since cleaning liquid or the like is supplied to the rotating wafer 101 from the supply nozzle 105, it is difficult to supply the cleaning liquid or the like uniformly on the surface 101A of the wafer 101 and, in addition, temperature control of the cleaning liquid or the like is difficult.

Furthermore, with the cleaning device 100, since the wafer 101 is rotated by the wafer receiving base 103, it is difficult to discharge unnecessary gas in a chamber 102 or in a cup 109 provided in the chamber 102 due to the influence of air current (turbulent flow or the like) generated upon rotation thereof.

In the case of the dip-type cleaning device, since cleaning liquid is filled in the cleaning bath, and the wafer is dipped therein for cleaning, there is a probability of occurrence of transfer contamination, that is, a probability that the surface of the wafer is contaminated by dirt on the rear face thereof.

### SUMMARY OF THE INVENTION

In view of such circumstances, it is an object of the invention to provide a cleaning device in which a front face and/or a rear face of a target object can be cleaned or rinsed simultaneously, and a transfer contamination on the front face due to cleaning liquid that has cleaned or rinsed the rear face is reliably prevented.

A cleaning device according to a first aspect of the invention is a cleaning device for cleaning or rinsing a target object disposed in a cleaning bath by cleaning fluid in the cleaning bath including: one side wall that configures the cleaning bath by being in abutment with a device body and is formed with an opening corresponding to a contour of the target object; holding means being capable of holding a rear face of the target object carried into the inner side of the one side wall through the opening from the outside of the one side wall and holding the target object in a vertically upright position; and a clearance defining member provided on a circumference of the opening on an inner surface of the one side wall for defining a clearance between the target object and the circumference of the opening by being in contact with the rear face of the target object.

Preferably, in the first aspect of the invention, the clearance between the circumference of the opening on the one side wall and the target object disposed in vertically upright position is set to be wider on the upper part then the lower part.

Preferably, in the first aspect of the invention, the cleaning device includes an ultrasonic vibration device arranged so as to oppose to and in parallel with the target object.

Preferably, in the first aspect of the invention, the one side wall is configured to be movable in an axial direction of the opening with respect to the device body, the target object is carried in and held by the holding means when the one side wall moves apart from the device body, and the cleaning bath is configured by abutment between the one side wall and the device body.

Preferably, in the first aspect of the invention, the holding means hold the rear face of the target object in a non-contact state by the action of a negative pressure generated by a whirling flow.

Preferably, in the first aspect of the invention, the holding means is installed on the one side wall so as to be capable of moving relatively with respect to the one side wall in the axial direction of the opening, and retracts form the target object when cleaning fluid is supplied into the cleaning bath to release the target object.

Preferably, in the first aspect of the invention, a receiving means is provided below the circumference of the opening on the inner surface of the one side wall, and the receiving member supports the target object in a point-contact state.

Preferably, in the first aspect of the invention, cleaning fluid filtered by a filter installed on the outside of the cleaning bath is circulated and supplied into the cleaning bath.

Preferably, in the first aspect of the invention, a drying fluid supply bath for introducing drying fluid into the cleaning bath is provided on the cleaning bath so as to continue therefrom.

Preferably, in the first aspect of the invention, the drying fluid supply bath includes a two-fluid nozzle to which organic solvent or inert gas at a high temperature is supplied, and the temperature of the organic solvent or the inert gas is a temperature at which the fluid can be vaporized simultaneously with injection of the fluid from the two-fluid nozzle.

Preferably, in the first aspect of the invention, the organic solvent is heated by a surface heat generating member wrapped around a pipe to be connected to the two-fluid nozzle.

Preferably, in the first aspect of the invention, vapor of the organic solvent is used first and then heated inert gas is used as the drying fluid.

A cleaning method according to a second aspect of the invention includes: a target object carrying step for carrying a target object into a cleaning bath, and mounting the target object to the cleaning bath with a front face thereof exposed into the cleaning bath and a rear face thereof exposed to the outside of the cleaning bath respectively while providing a clearance between the target object and the cleaning bath; and a cleaning/rinsing step for flowing the cleaning fluid in the cleaning bath, thereby cleaning or rinsing the front face of the target object that comes into contact with the cleaning fluid by the cleaning fluid, and cleaning or rinsing a rear face of the target object by the cleaning fluid flowing through the clearance by the action of the pressure of the cleaning fluid in the cleaning bath.

Preferably, in the second aspect of the invention, the cleaning method in the second aspect of the invention further includes a drying step for drying the target object by introducing a drying fluid in a state in which the target object is mounted in the cleaning bath after having finished the cleaning/rinsing step.

Preferably, in the second aspect of the invention, cleaning is preformed by using ultrasonic waves from an ultrasonic vibrating device arranged so as to oppose to and in parallel with the target object mounted to the cleaning bath in the cleaning/rinsing step.

Preferably, in the second aspect of the invention, vapor of the organic solvent is used first and then heated inert gas is used as the drying fluid in the drying step.

A holding device according to the third aspect of the invention is a cleaning device for cleaning or rinsing a target object disposed in a cleaning bath by cleaning fluid in the cleaning bath including: one side wall that configures the cleaning bath by being in abutment with a device body and is formed with an opening corresponding to a contour of the target object; holding means being capable of holding a rear face of the target object carried into the inner side of the one side wall through the opening from the outside of the one side wall and holding the target object in a vertically upright position; characterized in that the holding means hold the rear face of the target object in a non-contact state by the action of a negative pressure generated by a whirling flow.

A drying device according to the fourth aspect of the invention is a drying device for drying a target object disposed in a drying bath by drying fluid in the drying bath including: one side wall that configures the cleaning bath by being in abutment with a device body and is formed with an opening corresponding to a contour of the target object; holding means being capable of holding a rear face of the target object carried into the inner side of the one side wall through the opening from the outside of the one side wall and holding the target object in a vertically upright position; and clearance defining members provided on a circumference of the opening on an inner surface of the one side wall for defining a clearance between the target object and the circumference of the opening by being in contact with the rear face of the target object.

Preferably, in the fourth aspect of the invention, the drying bath includes a drying fluid supply bath for introducing the drying fluid into the drying bath.

Preferably, in the fourth aspect of the invention, organic solvent mist is used first and then heated inert gas is used as the drying fluid.

A cleaning device according to the fifth aspect of the invention is a cleaning device for cleaning a target object disposed in the cleaning bath by cleaning liquid in the cleaning bath including: one side wall that configures the cleaning bath by being in abutment with a device body and is formed with an opening corresponding to a contour of the target object, and is characterized in that the target object is oriented in a vertically upright position, the opening is closed by the peripheral edge of a surface opposite from a target surface being in tight contact with the circumference of the opening on the inner surface of the one side wall, and the target object is mounted to the cleaning bath with the target surface thereof exposed into the cleaning bath and the surface opposite from the target surface thereof exposed to the outside of the cleaning bath respectively.

A cleaning device according to the sixth aspect of the invention is a cleaning device for cleaning a target object disposed in a cleaning bath by cleaning liquid in the cleaning bath including: one side wall that configures the cleaning bath by being in abutment with a device body and is formed with an opening corresponding to a contour of the target object; and holding means for holding a surface of the target object opposite from a target surface through the opening from the outside of the one side wall and holding the target object through the opening, characterized in that the target object is oriented in a vertically upright position, the opening is closed by the peripheral edge of a surface opposite from a target surface being in tight contact with the circumference of the opening on the inner surface of the one side wall, and the target object is mounted to the cleaning bath with the target surface thereof being exposed into the cleaning bath and the surface opposite from the target surface thereof being exposed to the outside of the cleaning bath respectively by the holding means.

In the fifth aspect of the invention, preferably, cleaning liquid filtered by a filter arranged on the outside of the cleaning bath is circulated and supplied to the cleaning bath.

Preferably, in the fifth aspect of the invention, the cleaning device includes an ultrasonic vibration device arranged so as to oppose to and in parallel with the target object.

Preferably, in the fifth aspect of the invention, the one side wall is configured to be movable in an axial direction of the opening with respect to the device body, the target object is carried in and held by the holding means when the one side wall moves apart from the device body, and the cleaning bath is configured by abutment between the one side wall and the device body.

Preferably, in the sixth aspect of the invention, the holding means hold the rear face of the target object in a non-contact state by the action of a negative pressure generated by a whirling flow.

Preferably, in the fifth aspect of the invention, a drying fluid supply bath for introducing drying fluid into the cleaning bath is provided on the cleaning bath so as to continue therefrom.

Preferably, in the fifth aspect of the invention, the drying fluid supply bath includes a two-fluid nozzle for supplying organic solvent and inert gas at a high temperature, and the temperature of the organic solvent and the inert gas is a temperature at which the fluid can be vaporized simultaneously with injection of the fluid from the two-fluid nozzle.

Preferably, in the fifth aspect of the invention, the organic solvent is heated by a surface heat generating member wrapped around a pipe continued from the two-fluid nozzle.

Preferably, in the fifth aspect of the invention, vapor of the organic solvent is used first and then heated inert gas is used as the drying fluid.

A cleaning method according to the seventh aspect of the invention includes a target object carrying step for carrying a target object into a cleaning bath and mounting the target object in the cleaning bath with a target surface thereof exposed in the cleaning bath and a surface opposite from the target surface thereof exposed to the outside of the cleaning bath; and a cleaning step for flowing the cleaning liquid in the cleaning bath and cleaning the target surface of the target object that comes in contact with the cleaning liquid.

Preferably, in the seventh aspect of the invention, the cleaning method according to the seventh aspect of the invention further includes a drying step for drying the target object by introducing the drying fluid into the cleaning bath in a state in which the target object is mounted in the cleaning bath after having finished the cleaning method.

Preferably, in the seventh aspect of the invention, the cleaning process includes circulating the cleaning liquid between the filter installed outside of the cleaning bath and the cleaning bath.

Preferably, in the seventh aspect of the invention, cleaning is performed by using ultrasonic waves from a ultrasonic vibration device arranged so as to oppose to and in parallel with the target object.

Preferably, in the seventh aspect of the invention, vapor of the organic solvent is used first and then heated inert gas is used as the drying fluid.

According to the invention, the one side wall that configures the cleaning tank by abutting against the device body is provided with the opening corresponding to the contour of the target object, the holding means can hold the rear face of the target object carried into the inside of the one side wall, and the clearance is defined between the target object and the circumference of the opening by placing the target object in the vertically upright position and bringing the rear face of the target object into contact with the clearance defining member provided along the circumference of the opening on the inner surface of the one side wall. Therefore, when the cleaning fluid is supplied into the cleaning bath, the front face of the target object is cleaned or rinsed with the cleaning fluid in the cleaning bath and the rear face of the target object is cleaned or rinsed with the cleaning fluid flowing out from the cleaning bath through the clearance defined by the clearance defining member by the action of the pressure (hydraulic pressure) of the cleaning fluid in the cleaning bath. Consequently, the front face and the rear face of the target object can be cleaned or rinsed simultaneously. Furthermore, the end surface of the target object can be cleaned or rinsed in the course in which the cleaning fluid flows out from the cleaning bath through the clearance defined by the clearance defining member and cleans or rinses the rear face of the target object.

Since the cleaning fluid having used for cleaning or rinsing of the rear face of the target object does not flow into the cleaning bath by the action of the pressure (hydraulic pressure) of the cleaning fluid in the cleaning bath, transfer contamination of the front face of the target object by the cleaning fluid having used for cleaning or rinsing the rear face of the target object is reliably prevented.

According to the invention, the clearance between the circumference of the opening on the one side wall and the target object disposed in the vertically upright position is set to be wider on the upper part than the lower part. Therefore, the amount of the cleaning liquid or the rinsing liquid in the cleaning bath flowing out from the lower part of the clearance can be restricted, and hence the cleaning liquid or the rinsing liquid can be stored easily in the cleaning bath. In addition, by setting the upper part of the clearance to be wider, the amount of cleaning liquid or the rinsing liquid flowing out from the upper part is increased, and hence the entire back face of the target object can be cleaned and rinsed uniformly.

According to the invention, since the cleaning device is provided with the ultrasonic vibration device opposed to the target object substantially in substantially parallel thereto, the ultrasonic wave generated by the ultrasonic vibration device acts uniformly and entirely on the front face and the rear face of the target object, and hence the front face and the rear face of the target object can be cleaned uniformly and favorably.

According to the invention, since the rear face of the target object is held by the holding device in the non-contact state, the rear face of the target object is prevented from being contaminated by being held by the holding device, and such prevention of contamination can be achieved also on the end surface of the target object, which was difficult to clean since the chuck or the like is in contact thereto.

According to the invention, the holding device is installed on the one side wall so as to be capable of moving relatively with respect to the one side wall in the axial direction of the opening, and is adapted to be retracted from the target object and release the same. Therefore, the target object is held by the pressure (hydraulic pressure) of the cleaning liquid or the rising liquid when the cleaning liquid or the rinsing liquid is supplied into the cleaning bath, and otherwise, the target object is held by the holding device in the non-contact state, so that contamination is prevented in either cases. The end surface of the target object, which was difficult to clean since the shuck or the like is in contact thereto can also be prevented form being contaminated.

According to the invention, since the receiving member installed on the front wall supports the target object by a point-contact state, contamination that occurs when the target object is supported by the receiving member can be minimized.

According to the invention, since the cleaning liquid filtered by the filter installed on the outside of the cleaning bath is circulated and supplied into the cleaning bath, the amount of consumption of the cleaning liquid by repeated usage thereof, and the temperature control of the cleaning liquid can be achieved easily only by measuring and maintaining the temperature of the circulating cleaning liquid.

According to the invention, since the cleaning bath is provided with the drying fluid supply tank for introducing drying fluid into the cleaning bath so as to be continued therefrom, the target object can be dried by the above described drying fluid from the drying fluid supply bath in as state in which the target object is mounted in the cleaning bath. Therefore, the cleaning and rinsing process and the drying process can be performed consecutively and quickly.

According to the invention, since the temperatures of the organic solvent and inert gas supplied to the two-fluid nozzles 56 are temperatures at which the fluid can be vaporized simultaneously with injection of the fluid from the two-fluid nozzles, the displacement efficiency of water content attached on the target object is increased in comparison with the injection of the fluid, and not only the amount of injection, but also the amount of drainage can be reduced.

According to the invention, since the organic solvent is heated by the rubber heaters wrapped around the pipes, the organic solvent can be heated in a simple structure. In addition, by composing the pipes of SUS piping that restricts elusion of metal ion into water or high-purification chemicals, electro-static charge is prevented, and hence explosion proof is easily achieved for the combustible organic solvent.

According to the invention, since the vapor of the organic solvent is used as the drying fluid first to displace water content attached on the target object, and then the heated inert gas is used for quickly drying the target object, the water content attached to the target object can be dried reliably and quickly.

According to the invention, since the target object is mounted to the cleaning tank with a clearance defined between the cleaning tank with the front face exposed into the cleaning tank and the rear face exposed to the outside of the cleaning tank, the front face of the target object that comes into contact with the cleaning fluid in the cleaning tank can be cleaned and rinsed by the cleaning fluid, and since the rear face of the target object can be cleaned or rinsed by the cleaning fluid flowing out from the clearance, the front face and the rear face of the target object can be cleaned or rinsed simultaneously. Furthermore, the end surface of the target object can be cleaned or rinsed in the process in which the cleaning fluid flows out from the cleaning bath via the clearance and cleans or rinses the rear face of the target object.

Since the cleaning fluid having used for cleaning or rinsing the rear face of the target object does not enter into the cleaning bath by the action of the pressure (hydraulic pressure) of the cleaning fluid in the cleaning bath, the transfer contamination of the front face of the target object by the cleaning fluid having used for cleaning or rinsing the rear face of the target object is reliably prevented.

According to the invention, since the drying fluid is introduced into the cleaning bath in a state in which the target object is mounted in the cleaning bath to dry the target object after having finished the cleaning and rinsing process for the target object, the cleaning and rinsing process and the drying process can be performed consecutively and quickly.

According to the invention, since the cleaning or rinsing is performed using ultrasonic wave from the ultrasonic vibration device installed so as to oppose to and in parallel with the target object mounted to the cleaning bath in the cleaning/rinsing process, the ultrasonic wave acts on the front face and the rear face of the target object uniformly, and hence cleaning or rinsing can be performed favorably without unevenness.

According to the invention, since the holding device for the target object holds the rear face of the target object in the non-contact state, the rear face can be prevented from being contaminated by being held by the holding device the holding device, and such prevention of contamination can be achieved also on the end surface of the target object, which was difficult to clean since the chuck or the like is in contact thereto.

According to the invention, since the target object can be dried in the vertically upright position by the holding means, reduction of the space required for the drying bath, and hence the space required for the entire drying device can be achieved.

According to the invention, the one side wall of the cleaning bath is formed with the opening, the target object is placed in the vertically upright position, the peripheral edge of the surface opposite form the target surface is brought into tight contact with the circumference of the opening in the inner surface of the one side wall to close the opening, and the target object is mounted in the cleaning bath with the target surface exposed in the cleaning bath and the surface opposite from the target exposed to the outside of the cleaning bath. Therefore, since the cleaning liquid comes into contact with the target surface of the object and not with the surface opposite from the target surface, transfer contamination on the target surface of the target object due to dirt on the surface opposite from the target surface of the wafer running up to the target surface is reliably prevented. In this case, since the target object is mounted to the cleaning bath with the surface opposite from the target surface of the target object exposed into the cleaning bath, the end surface of the target object can also be cleaned.

According to the invention, since the ultrasonic vibration device is arranged in the cleaning device so as to oppose to and in parallel with the target object, the ultrasonic waves generated by the ultrasonic vibration device acts on the entire surface of the target surface of the target object uniformly, and hence the processing surface of the target object can be cleaned favorably without unevenness.

According to the invention, since the target object is carried in and mounted to the cleaning tank with the target surface exposed into the cleaning bath and the surface opposite from the target surface exposed to the outside of the cleaning bath respectively, the cleaning liquid comes into contact with the target surface of the target object but not with the surface opposite from the target surface. Therefore, transfer contamination on the target surface of the target object due to dirt on the surface opposite from the target surface of the wafer running up to the target surface is reliably prevented.

According to the invention, since the cleaning is performed using the ultrasonic wave from the ultrasonic vibration device installed so as to oppose to and in parallel with the target object mounted in the cleaning bath, the ultrasonic wave acts on the target surface of the target object uniformly and cleaning can be performed favorably without unevenness.

### BRIEF DESCRIPTION OF THE DRAWINGS

Fig. 1 is a perspective view, partly broken, of a cleaning facility in which a cleaning device according to a first embodiment of the invention is provided;
Fig. 2 is a perspective view showing a waiting state of the cleaning device in Fig. 1 when viewed obliquely from the front side thereof;
Fig. 3 is a perspective view showing the waiting state of the cleaning device in Fig. 1 when viewed obliquely from the back side thereof;
Fig. 4 is a front view of the cleaning device shown in Fig. 2, showing a state of carrying in and out the wafer;
Fig. 5 is a drawing viewed in the direction indicated by an arrow V in Fig. 4.
Fig. 6 is a side view of the cleaning device in Fig. 2 showing a state of transferring the wafer;
Fig. 7 is a front view of the cleaning device in Fig. 2 showing a state of setting the wafer or drying the wafer;
Fig. 8 is a drawing viewed in a direction indicated by an arrow VIII in Fig. 7;
Fig. 9 is a side view of the cleaning device in Fig. 2 showing a state of cleaning the wafer or rinsing the wafer.
Fig. 10 is a cross-sectional view showing part of Fig. 8 in an enlarged scale;
Fig. 11 is a perspective view showing a circumference of the opening on the front wall in Fig. 10;
Fig. 12 is a perspective view of the wafer holding device in the cleaning device in Fig. 2 showing together with the holding device cylinder;
Fig. 13 is a perspective view showing a general configuration for explaining a principle of the cleaning device in Fig. 2;
Fig. 14 is cross-sectional view of part of Fig. 10 in an enlarged scale shown with a flow of IPA vapor;
Fig. 15 is a cross-sectional view of part of Fig. 13 in an enlarged scale shown with a flow of cleaning liquid or rinsing liquid;
Fig. 16 is a flowchart showing part of the operation in the cleaning device in Fig. 2;
Fig. 17 is a flowchart showing the remaining operation of the cleaning device in Fig. 2;
Fig. 18 is a perspective view of the cleaning device in a waiting state viewed obliquely from the front side;
Fig. 19 is a side view of the cleaning device in Fig. 18 showing state of carrying in and out the wafer;
Fig. 20 is a front view showing a state of processing the wafer such as cleaning in the cleaning device shown in Fig. 18;
Fig. 21 is a drawing viewed in a direction indicated by an arrow VII in Fig. 20;
Fig. 22 is a cross-sectional view showing a general structure for explaining the principle of the cleaning device in Fig. 2;
Fig. 23 is a cross-sectional view showing part of Fig. 22 in an enlarged manner; and
Fig. 24 is a general cross-sectional view of the cleaning device in the related art.

### DESCRIPTION OF THE PREFERRED EMBODIMENTS

Referring now to the drawings, referred embodiments of the invention will be described.

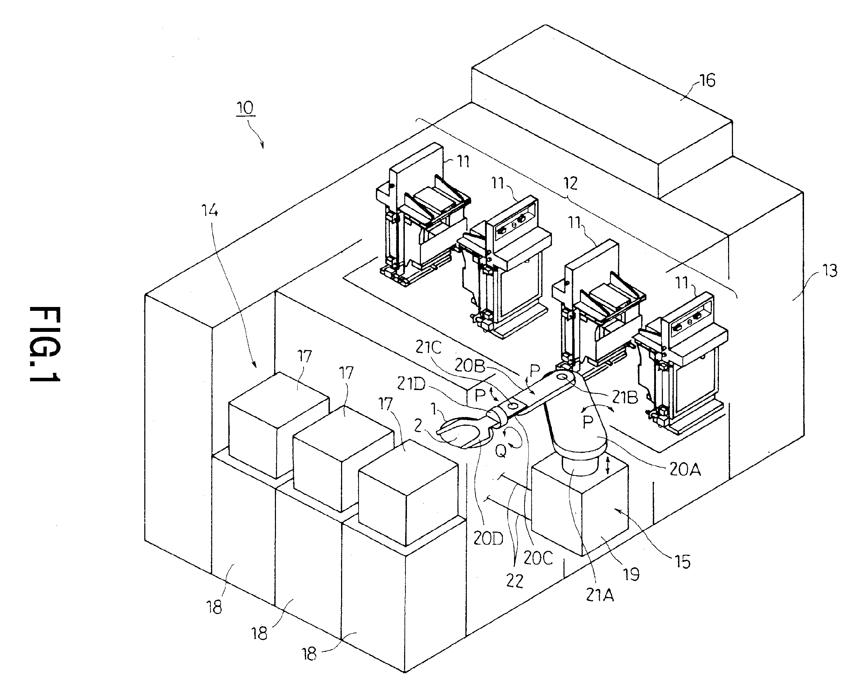

### A. First Embodiment (Fig. 1 to Fig. 17)

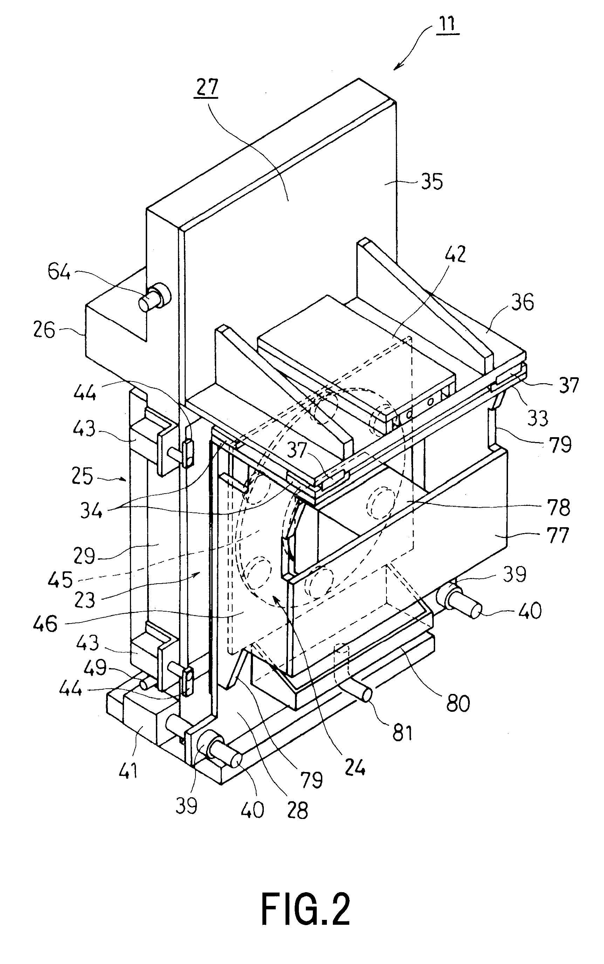

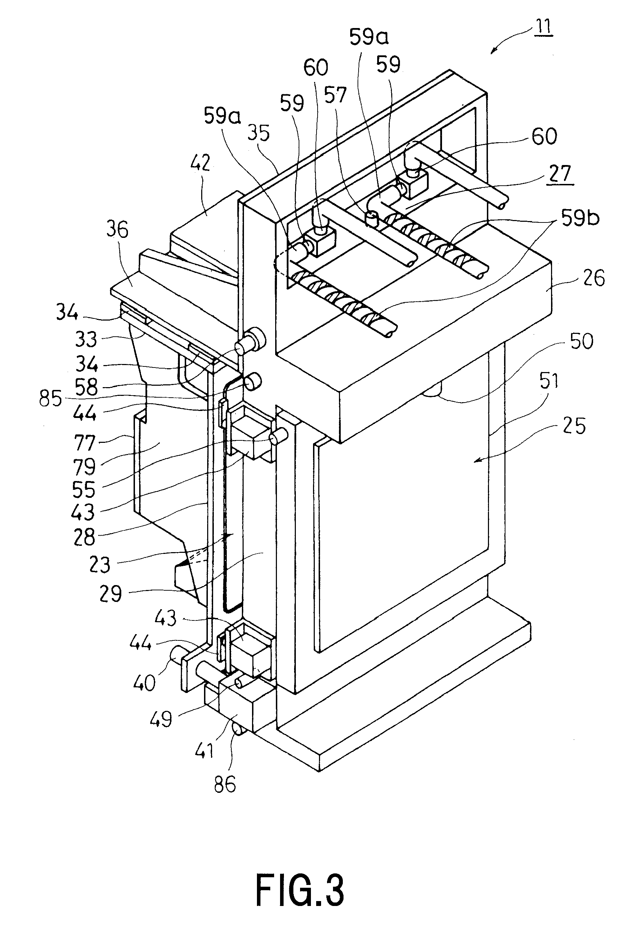

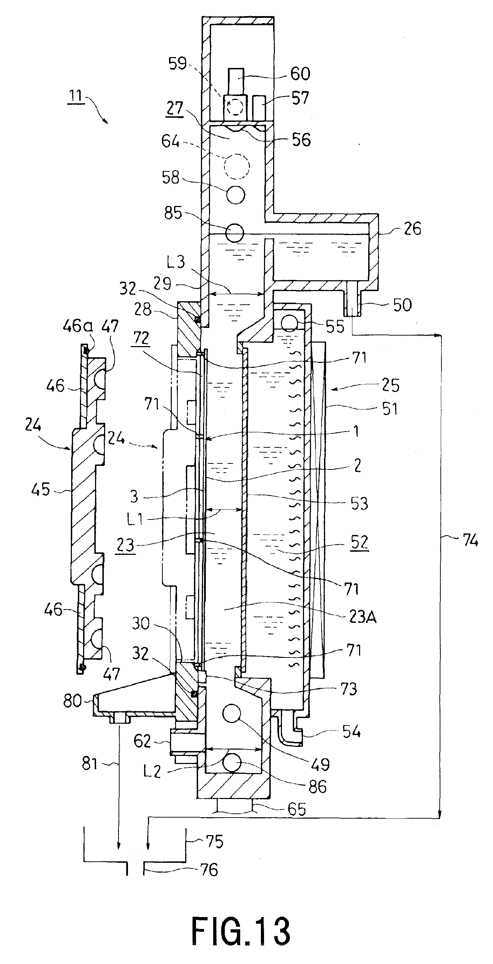

Fig. 1 is a perspective view, partly broken, of a cleaning facility in which a cleaning device according to a first embodiment of the invention is provided. Fig. 2 is a perspective view showing a waiting state of the cleaning device in Fig. 1 when viewed obliquely from the front side thereof. Fig. 3 is a perspective view showing the waiting state of the cleaning device in Fig. 1 when viewed obliquely from the back side thereof. Fig. 13 is a perspective view showing a general configuration for explaining a principle of the cleaning device in Fig. 2.

The cleaning facility 10 shown in Fig. 1 includes a cleaning device layout section 12 in which a plurality of cleaning devices 11 (describe later in detail) for cleaning a semiconductor substrate (a wafer 1, for example) as a target object are arranged, a chemical supply unit arranged adjacently to the washing device layout section 12, a wafer supply/discharge section 14 arranged at a position on the opposite side from the chemical supply unit 13, a carrier robot 15 arranged between the cleaning device layout section 13 and the wafer supply/discharge section 14, and an electric unit 16 arranged above the chemical supply unit 13.

The chemical supply unit 13 supplies alkaline cleaning liquid, acid cleaning liquid, pure water as rinsing liquid, organic solvent or inert gas as crying fluid to the cleaning device in the cleaning device layout section 12. The cleaning liquid and rinsing liquid are referred to as cleaning fluid. The wafer supply/discharge section 14 includes a placement base 18 for placing a wafer carrier container (so-called hoop) 17 in which a plurality of wafers 1 are stored in the horizontal state and a container opener, not shown, for opening and closing a lid of the wafer carrier container 17. When the wafer 1 in the wafer carrier container 17 is fed to the cleaning device 11, or when the wafer 1 processed the cleaning device 11 is stored in the wafer carrier container 17, the container opener opens the lid of the wafer carrier container 17.

The carrier robot 15 includes a robot body 19 which is provided with a first arm 20A, a second arm 20B, a third arm 20C, and a hand section 20D connected in sequence thereto. A first shaft 21A is provided between the robot body 19 and the first arm 20A, a second shaft 21b is provided between the first arm and the second arm 20B, a third shaft 21C is provided between the second arm and the third arm 20C, and a fourth shaft 21D is provided between the third arm 20C and the hand section 20D, respectively. The first arm 20A, the second arm 20B, and the third arm 20C are provided so as to be capable of rotating in a horizontal plane as indicated by an arrow P via the first arm 20A, the second arm 20B, and the third arm 20C, and the hand section 20D is provided on the third arm 20C so as to be capable of rotating between the horizontal plane and the vertical plane via the fourth shaft 21D, that is, so as to be capable of rotating in the direction indicated by an arrow Q. The robot body 19 is configured so as to be capable of moving along a rail 22 in the direction of alignment of the cleaning devices 11 in the cleaning device layout section 12.

The hand section 20D is provided with a non-contact holding member (not shown) that holds a surface2 of the wafer 1 to be processed in a non-contact state by the action of negative pressure generated by whirling flow as in the case of a wafer holding device 24 (Fig. 2) described later in the cleaning device 11.

Therefore, the carrier robot 15 inserts the hand section 20D into the wafer carrier container 17 by the action of the first arm 20A, the second arm 20B and the third arm 20C when the wafer carrier container 17 in the wafer supply/discharge section 14 is opened, holds the front face 2 of the wafer 1 in the non-contact state, moves the robot body 19 along the rail 22 and transfers the wafer 1 held by the hand section 20D to the wafer holding device 24 (Fig. 2) of a desired cleaning device. The carrier robot 15 holds the front face 2 of the wafer 1 which is cleaned and dried by the cleaning device 11 in the non-contact state with the hand section 20D to receive the same from the wafer holding device 124 in the cleaning device 11, and stores the wafer 1 in the wafer carrier container 17 in the wafer supply/discharge by the action of the robot body 19, the first arm 20A, the second arm 20B and the third arm 20C.

The electric unit 16 supplies an electric power to the respective cleaning devices in the cleaning device layout section 12, the chemical supply unit 13, a wafer supply/discharge section 14 and the carrier robot 15. The electric unit 16 is arranged above the chemical supply unit 13, and hence it is prevented from getting wet with liquid such as cleaning liquid. The cleaning facility 10 is further provided with various pipes above and below the cleaning device layout section 12.

As shown in Fig. 2 to Fig. 9 and Fig. 13 (in particular in Fig. 13), the cleaning device 11 includes a box-shaped device body 29 as a basic structure, and in the device body 29 there are provided a flat box-shaped cleaning bath 23 for storing cleaning liquid and pure water for cleaning the wafer 1, a wafer holding device 24 for mounting the wafer in the cleaning bath 23, an relay bath 52 provided adjacently to and in parallel with the cleaning bath 23 on the opposite side from the wafer holding device 24 by being partitioned by a quartz plate 53, an ultrasonic vibration device 25 provided adjacently to the relay bath 52 on the opposite side from the cleaning bath 23, a first overflow bath 26 provided above and adjacent to the cleaning bath 23, and a drying fluid supply bath 27 provide above the cleaning bath 23 so as to be continued from the cleaning bath 23 for introducing drying fluid into the cleaning bath 23.

The flat box-shaped cleaning bath 23 is defined by a front wall 28 as one side wall which abuts against the cleaning bath component part 23A in the device body 29 at a position opposing to the quartz plate 53. The front wall is formed with an opening 30 of a shape corresponding to a contour of the wafer 1.

A seal member 32 is arranged on an inner surface of the front wall 28 on an area that abuts against the device body 29.

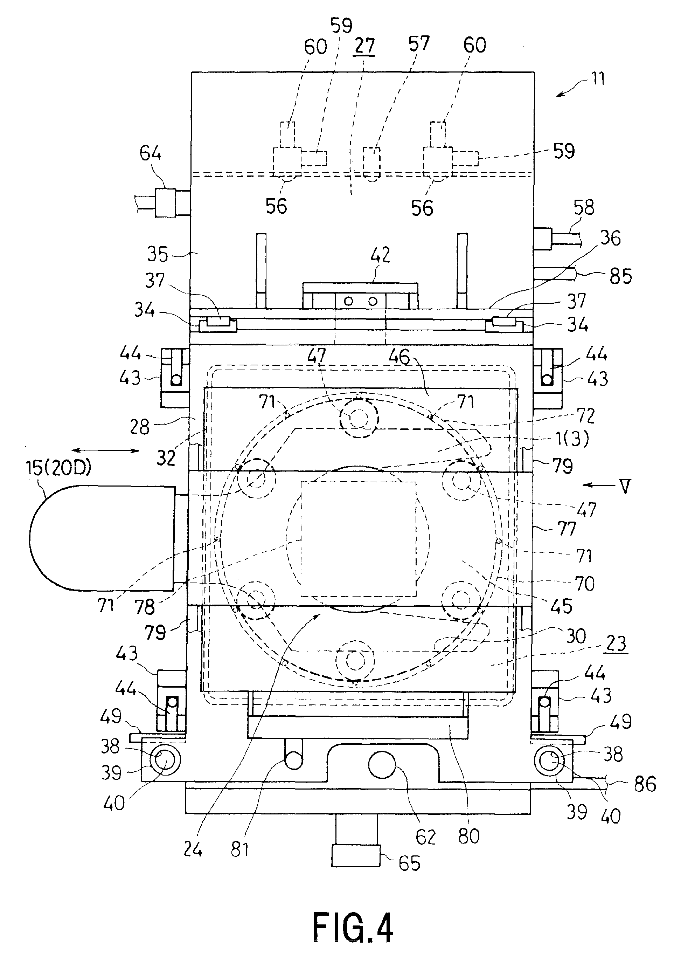

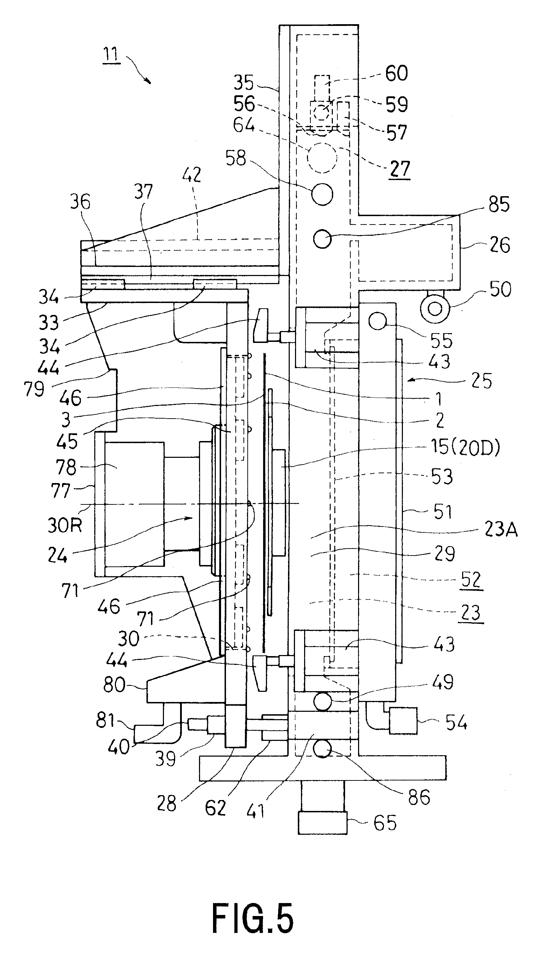

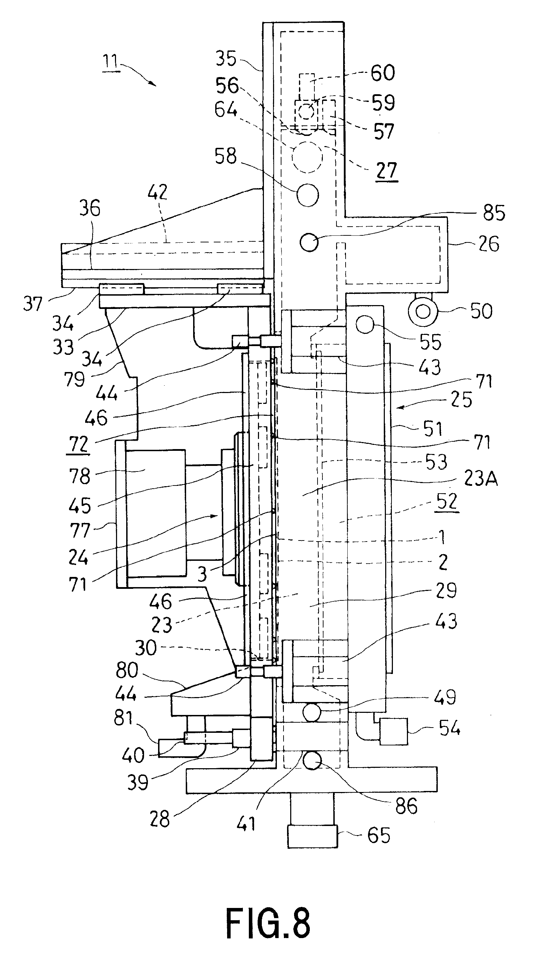

As shown in Fig. 5 and Fig. 8, a horizontal plate 33 is orthogonally connected to an upper end of the front wall, and a slider 34 is mounted to the horizontal plate 33. A base plate member 35 of an L-shape in side view is secured to the drying fluid supply bath 27 which is located above the cleaning bath 23, and a rail 37 is provided on the horizontal plate 36 of the base plate member 35. The slider 34 is slidably fitted to the rail 37. As shown in Fig. 4 and Fig. 5, the front wall 38 is formed with a through hole 38 on the lower part thereof, and a bush 39 is secured thereto coaxially with the through hole 38. A supporting shaft 40 is mounted to the lower part of the device body 290 via a shaft base 41. The supporting shaft 40 is slidably inserted into the through hole 38 and the bush 39.

As shown in Fig. 2, the horizontal plate 36 of the base plate member 35 is provided with a rodless slide cylinder 42, and a piston, not shown, of the slide cylinder 42 is connected to the horizontal plate 33 of the front wall 28 through the horizontal plate 36. Therefore, the front wall is configured to be movable along an axial direction 30R (Fig. 5) of the opening 30 with respect to the device body 29 by being guided by the rail 37 and the slider 34, and the supporting shaft 40 and the bush 39 by the operation of the slide cylinder 42, for example, with a stroke of 75 mm.

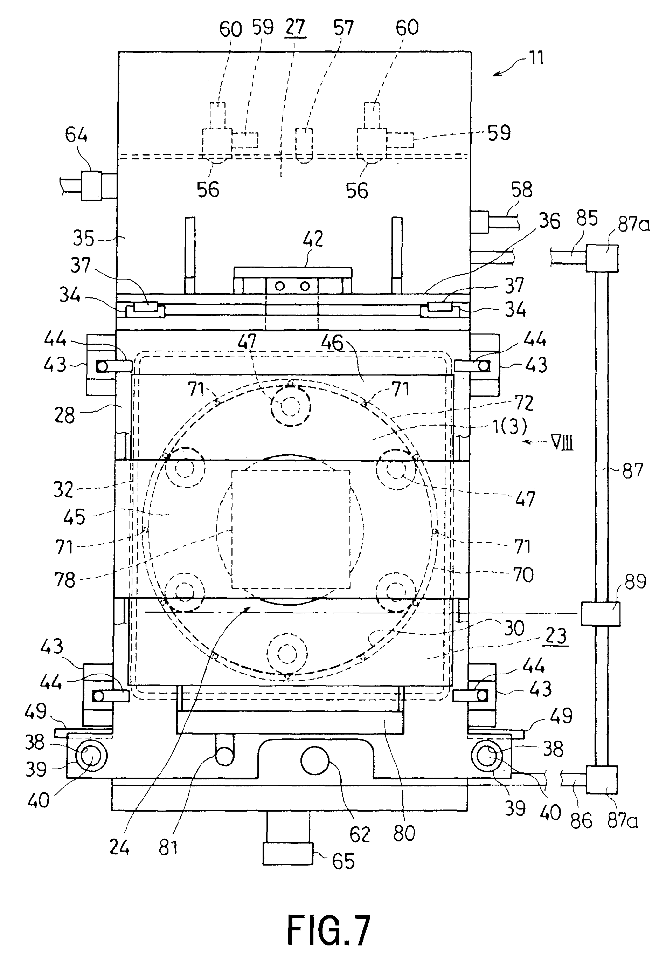

As shown in Fig. 4 and Fig. 5, clamp cylinders 43 are provided on both sides of the device body 29 on top and bottom thereof, and clampers 44 are mounted to rods of the clamp cylinders 43. When the front wall 28 and the device body 29 are in abutment with each other as shown in Fig. 7 and Fig. 8, and the clamp cylinders 43 are activated, and the clamper 44 press the front wall 28 against the device body 29, whereby the front wall 28 is integrated with the device body 29 and the cleaning bath 23 is configured. At this time, the seal member 32 of the front wall 28 (Fig. 7 and Fig. 13) comes into tight contact with the device body 29, so that sealing property between the front wall 28 and the device body 29 is favorably secured.

As shown in Fig. 4, Fig. 5 and Fig. 12, a base portion 45 of the wafer holding device 24 is formed into a disk shape corresponding to the size of the wafer 1, and is formed with, for example, six recesses 47 as non-contact holding member on the inner side of the end portion thereof at regular intervals. As stated in JP-A-2002-64130, a whirling flow is generated in the recesses 47 (Fig. 4, Fig. 10 and Fig. 12) and hence a negative pressure is generated in the recesses 47, so that the rear face 3 (a surface of the wafer 1 opposite from the front face 2) of the wafer 1 is held in a non-contact state by the action of the negative pressure as if it sticks to the recesses 47. For example, the wafer is held by the wafer holding device 24 in the non-contact state in a state in which a clearance of about 0.25 mm is secured with respect to the recesses 47 of the wafer holding device 24.

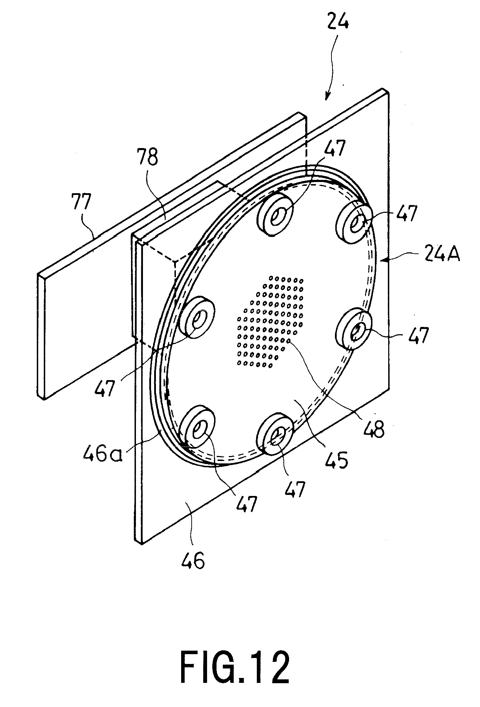

As shown in Fig. 12, a drying fluid supply holes 48 composed of a plurality of holes are formed at a inner center of the disk-shaped base portion 45, so that drying fluid such as nitrogen gas at a high temperature can be supplied from these holes to the rear face 3 of the wafer 1. As shown in Fig. 12 to Fig. 14, a plate-shaped cover 46 that comes into abutment with the front wall 28 is disposed on the outside of the disk-shaped base portion 45 so as to cover the base portion 45 in order to expose also the rear face of the wafer 1 in the IPA vapor atmosphere during the drying process, and the seal member 46a is disposed on the inner surface of the cover 46 that comes into abutment with the front wall 28.

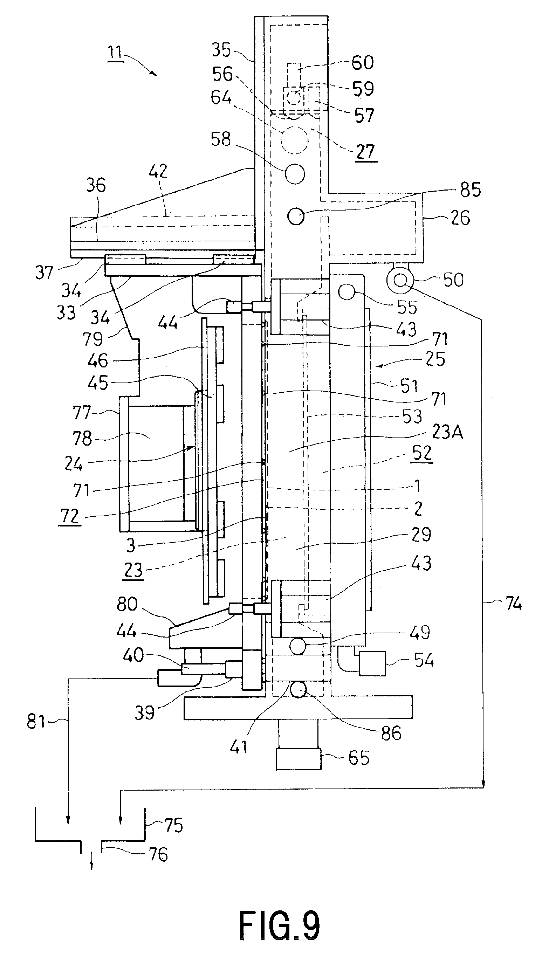

As shown in Fig. 2, Fig. 5 and Fig. 12, side plates 79 are disposed on both sides of the front wall 28, and a holding device cylinder 78 is arranged on the side plate 79 via a mounting plate 77. The wafer holding device 24 is mounted to a distal end of the rod of the holding device cylinder 78. As show n in Fig. 8, and Fig. 9, the holding device cylinder 78 allows the wafer holding device 24 to move along the axial direction 39R of the opening 30 relatively with respect to the front wall 28 by the fore-and-aft movement of the rod. The amount of movement (stroke) of the wafer holding device 24 allowed by the cylinder 37 for the holding device is, for example, 30 mm.

The holding device cylinder 78 78 causes the wafer holding device 24 to be inserted and positioned in the opening 30 on the front wall 28 by the forward movement of the rod. In this case, the cover 46 of the wafer holding device 24 abuts against the front wall 28 and the seal member 46a of the cover 46 (Fig. 12 to Fig. 14) comes into tight contact with the front wall 28, so that the sealing property between the cover 46 and the front wall 28 is favorably secured. The holding device cylinder 78 moves the wafer holding device 24 out of the opening 30 of the front wall 28 by the backward movement of the rod when cleaning or rinsing the wafer 1 (Fig. 9).

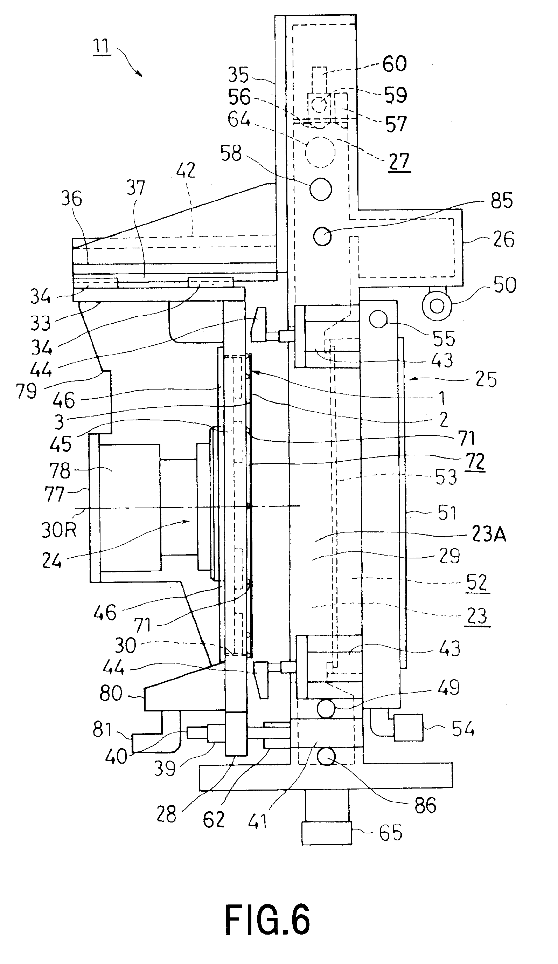

As described above, the front wall 28 can be moved along the axial direction 30R of the opening 30 with respect to the device body 29. When the wafer 1 is carried in/out or transferred and hence the front wall 28 is moved apart from the device body 29 (Fig. 5 and Fig. 6), the wafer holding device 24 is inserted and positioned in the opening of the front wall 28 by the holding device cylinder 78. Therefore, when the front wall 28 moves apart from the device body 29, and the hand section 20D of the carrier robot 15 enters between the front wall 28 and the device body 29 while holding the front face 2 of the wafer 1 in the non-contact state, the wafer holding device 24 holds the rear face 3 of the wafer 1 in the non-contact state through the opening 30 from the outside of the front wall 28 by the action of the negative pressure. Then, the wafer 1 is transferred to the wafer holding device 24, and carried into the cleaning bath 23 of the cleaning device 11. At this time, the wafer is held in the vertically upright position by the wafer holding device 24. After the wafer 1 is carried into the cleaning bath 23, as shown in Fig. 8, Fig. 10, and Fig. 13, the front wall 28 comes into abutment with the device body 29 and hence the cleaning bath 23 is configured, whereby cleaning liquid or the like can be stored therein and hence cleaning can be performed.

As shown in Fig. 7, Fig. 8 and Fig. 11, a counter sunk surface 70 is formed along the circumference of the opening 30 on the outer surface of the front wall 28, and pins 71 as clearance defining member are implanted along the counter sunk surface 70. A plurality of, for example, twelve pins are provided along circumference of the opening 30.

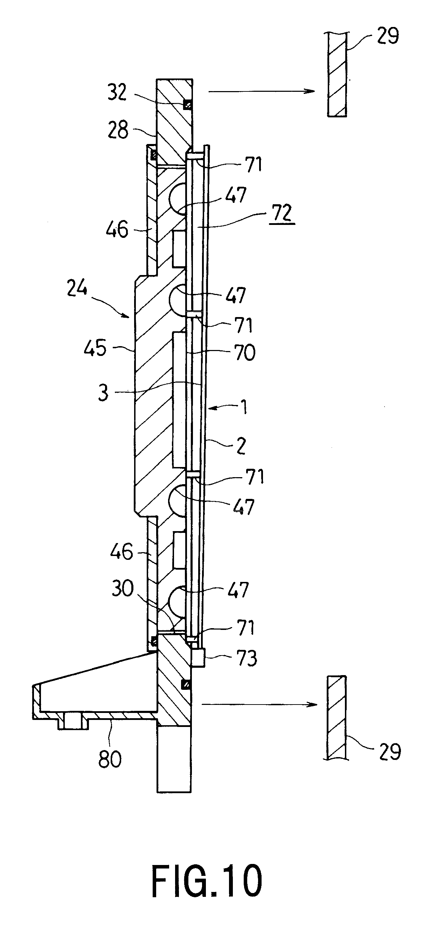

The peripheral edge portion of the rear face 3 of the wafer 1 carried in the cleaning bath 23 comes in contact with the pins 71 so that the wafer 1 is held in the vertically upright position by the action of a negative pressure of the wafer holding device 24 when the wafer 1 is transferred (Fig. 6), set, or dried (Fig. 8), by the pressure (hydraulic pressure) of cleaning liquid or rinsing liquid in the cleaning bath 23 when the wafer 1 is cleaned or rinsed (Fig. 9) described later, and by a surface tension of residual cleaning liquid or the like at contact points between the pins 71 and the rear face 3 of the wafer 1. Therefore, the wafer 1 is mounted to the cleaning bath 23 in such a manner that the front face 2 thereof is exposed in the cleaning bath 23 and the rear face 3 thereof is exposed out of the cleaning bath 23, and closes the opening 39 while forming an annular clearance 72 between the wafer 1 and the circumference of the opening of the front wall 28 by the pins 71 as shown in Fig. 10.

When the wafer 1 is cleaned or rinsed, as shown in Fig. 8 and Fig. 13, cleaning liquid or rinsing liquid is introduced from the cleaning liquid supply port 49 provided on the lower part of the device body 29 into the cleaning bath 23. The cleaning liquid or the rinsing liquid flows in the cleaning bath 23 upward and cleans or rinses the surface of the wafer 1, and then is stored temporarily in the first overflow bath 26. The cleaning liquid or the rinsing liquid stored in the first overflow bath 26 flows through the over flow bath drain port 50 provided on the first overflow bath 26 and the drainpipe 74 and is stored in a drainage bath 75, and is discharged from the drain port 76 provided on the drainage bath 75. The cleaning liquid discharged from the drain port 76 is filtered by a filter and a circulation pump, and is returned to the cleaning bath 23.

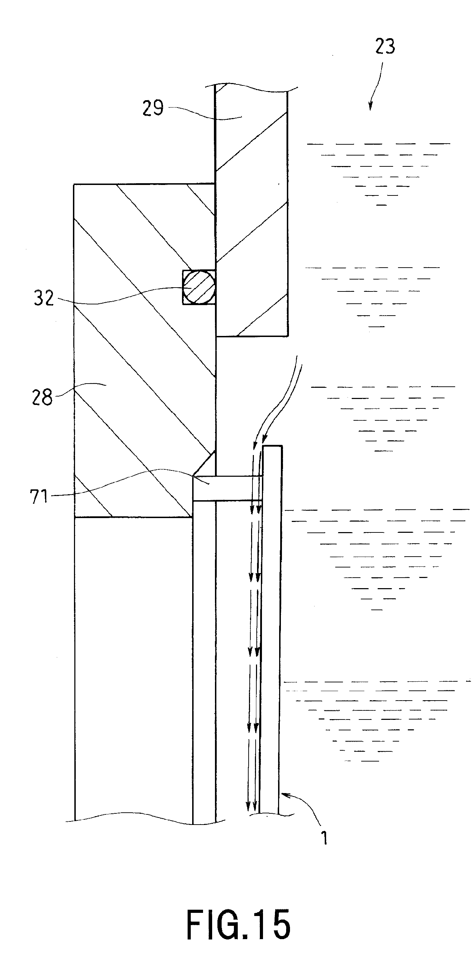

When the wafer 1 is cleaned or rinsed, as indicated by an arrow in Fig. 15, cleaning liquid or rinsing liquid in the cleaning bath 23 is flown out from the cleaning bath 23 through the annular clearance 72 formed by the pins, and the cleaning liquid or the rinsing liquid cleans or rinses the rear face 3 of the wafer 1. The cleaning liquid or the rinsing liquid having flowed through the annular clearance 72 out of the cleaning bath 23 and cleaned or rinsed the rear face 3 of the wafer 1 does not flow into the cleaning bath 23 by the action of the pressure (hydraulic pressure) of the cleaning liquid or the rinsing liquid in the cleaning bath 23. Therefore, the front face 2 of the wafer 1 is not subject to the transfer contamination by the cleaning liquid or the rinsing liquid having cleaned or rinsed the rear face 3 of the wafer 1. The end surface of the wafer 1 is also cleaned or rinsed in the course in which the cleaning liquid or the rinsing liquid is flowed out from the cleaning bath 23 via the annular clearance 72 and cleans or the like the rear face 3 of the wafer 1.

As described above, since fluid such as cleaning liquid runs along the rear face 3 of the wafer, the wafer holding device 24 moves apart from the opening 30 of the front wall 28 (Fig. 9) by the holding device cylinder 78 when cleaning or rinsing the wafer 1, and is retracted from the wafer 1 that is in contact with the pins 71 to release the wafer 1 from being held. At this time, the wafers 1 is kept in a state of being in contact with the pins by the pressure (hydraulic pressure) of the cleaning liquid or the rinsing liquid supplied into the cleaning bath 23.

In this case, the projecting lengths of the pins 71 are set to be larger for the pins 71 which are located on the upper part of the opening 80 than those located on the lower part thereof on the front wall 28. Accordingly, the upper part of the annular clearance 72 is set to be wider than the lower part thereof. For example, the dimension of the uppermost part of the annular clearance 72 is set to 1.0 mm, and the dimension of the lowermost part thereof is set to 0.1 mm respectively. By setting the lower part of the annular clearance 72 to be narrower, cleaning liquid or rinsing liquid can be stored easily in the cleaning bath 23 when cleaning or rinsing the wafer 1 shown in Fig. 13. By setting the upper part of the annular clearance to be wider, the entire rear face 3 of the wafer 1 is cleaned or rinsed uniformly by cleaning liquid or rinsing liquid flowing out from the annular clearance 72 when cleaning or rinsing the wafer 1. Such uniform cleaning or rinsing of the rear face 3 of the wafer 1 is achieved by a multiplier effect with the flow velocity of cleaning liquid or a rinsing liquid flowing in the cleaning bath 23.

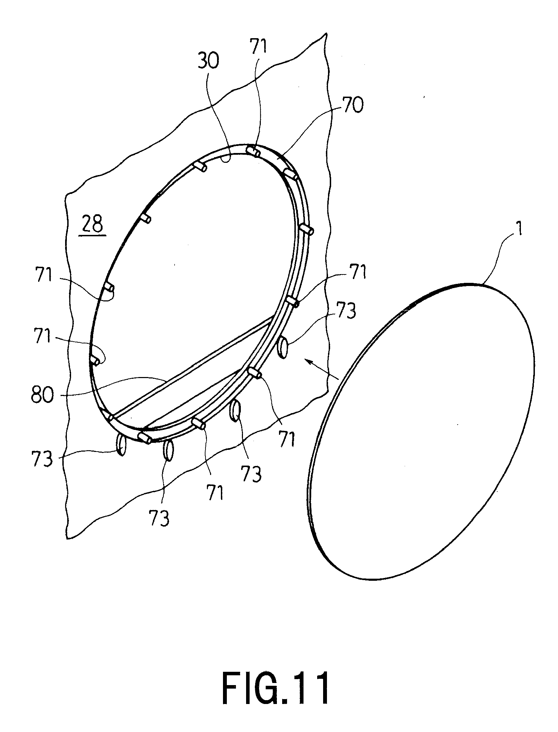

In the embodiment shown above, the counter sunk surface 70 where the pins 71 are implanted is parallel with the vertical plane as shown in Fig. 10 and 11. However, it is also applicable to cut the counter sunk surface 70 deeper on the upper part so as to be inclined with respect to the vertical plane. When the plurality of pins 71 are implanted into the counter sunk surface 70 so as be projected in different lengths as described above, the wafer 1 that comes in contact with the pins 71 can be arranged in parallel with the vertical plane. By arranging the wafer 1 in parallel with the vertical plane, the ultrasonic transducer 51 to be mounted on the back surface of the relay bath 52 and the wafer 1 can be arranged easily in parallel, so that the distance between the wafer 1 and the ultrasonic transducer 51 is completely uniform at any part thereof, whereby uneven cleaning in the ultrasonic cleaning can easily be prevented.

A receiving member 73 is installed below the circumference of the opening 30 on the outer surface of the front wall 28. The receiving member 73 is formed into a tapered shape on the upper part thereof that supports the wafer 1 so s to support the peripheral edge of the wafer 1 in a point contact state, so that transfer of contamination or the like to the wafer is restrained. The lower part of the receiving member 73 is also formed into a tapered shape so as to achieve favorable liquid drainage.

As shown in Fig. 7, Fig. 9 and Fig. 13, the second overflow bath 80 is installed below the circumference of the opening 30 on the outer surface of the front wall 28. The second overflow bath 80 receives and stores cleaning liquid or rinsing liquid having flowed out from the annular clearance 72 and used for cleaning or rinsing the rear face 3 of the wafer 1 temporarily. The cleaning liquid or the rinsing liquid collected in the second overflow bath 80 is introduced into the drainage bath 75 via the drain pipe 81 and is discharged from the drain port 76 of the drainage bath 75 together with cleaning liquid or rinsing liquid from the first overflow bath 26 from the drain port 76 of the drainage bath 75. Cleaning liquid introduced from the second overflow bath 80 to the drainage bath 75 is also filtered by the filter and the circulating pump, not shown, and returned into the cleaning bath 23 together with the cleaning liquid introduced from the first overflow bath 26 to the drainage bath 75 as described above.

The cleaning bath 23 is partitioned from the relay bath 52 by a quartz plate 53 described above, and a length L1 (Fig. 13) between the wafer 1 and the quartz plate 53 in the cleaning bath 23 is set to be narrower than a length L2 of the lower part of the cleaning bath 23 provided with the cleaning liquid supply port 49 and a length L3 of the upper part of the cleaning bath 23 which is continued to the first overflow bath 26. Accordingly, the flow velocity of cleaning liquid or rinsing liquid that flows through the center of the cleaning bath 23 is increased, whereby improvement of efficiency of cleaning or rinsing the front face 2 of the wafer 1 disposed in the cleaning bath 23 is achieved, and uniform cleaning or rinsing of the entire rear face 3 of the wafer 1 by cleaning liquid or rinsing liquid flowing out from the annular clearance 72 is achieved. For example, the length L1 is set to about 5 mm and the lengths L2 and L3 are set to about 35 mm, respectively.

As shown in Fig. 3, Fig. 9 and Fig. 13, the ultrasonic vibration device 25 includes the ultrasonic transducer 51, the relay bath 52, the quarts plate 53, and a high-frequency oscillator, not shown. As described above, the relay bath 52 is adjacent to the cleaning bath 23 via the quartz plate 53, and is filled with pure water as an ultrasonic wave transmitting medium. The relay bath 52 is provided with a relay bath supply/drain port 54 on the lower part thereof, and a relay bath overflow port 55 on the upper part thereof, respectively, so that fresh pure water is introduced from the relay bath supply/drain port 54 into the relay bath 52, and when the fact that the pure water in the relay bath 52 is drained via the relay bath overflow port 55 is determined, the ultrasonic vibration device 55 is activated.

The ultrasonic transducer 51 is mounted to the back surface of the relay bath 52, and the ultrasonic transducer 51 and the quartz plate 53 are arranged to oppose the wafer 1 mounted to the cleaning bath 23 in substantially parallel therewith. A high-frequency signal from the high-frequency oscillator is transmitted to the ultrasonic transducer 51, whereby the ultrasonic transducer 51 generates ultrasonic vibrations, and the ultrasonic vibrations transmits through the pure water and the quartz plate 53 in the relay bath 52 to the cleaning liquid or the rinse liquid in the cleaning bath 23, thereby cleaning or rinsing the front face 2 of the wafer 1 with ultrasonic waves. Then, the ultrasonic vibrations having reached the cleaning bath 23 is propagated though the waver 1 to cleaning liquid or rinsing liquid flowing on the rear face 3 of the wafer 1 so that the rear face 3 of the wafer 1 can be cleaned or rinsed with ultrasonic waves. Consequently, the front face 2 and the rear face 3 of the wafer 1 can be cleaned or rinsed entirely and uniformly. By the action of the ultrasonic wave, the efficiency of cleaning the wafer with alkaline cleaning liquid or the efficiency of rinsing with rinsing liquid (pure water) after alkaline cleaning are improved.

As shown in fig 3, Fig. 7 and Fig. 8, the drying fluid supply bath 27 includes a plurality of two-fluid nozzles 56, a pure water nozzle 57, and a gas supply unit 58 for supplying fluid into the cleaning bath 23, and the two-fluid nozzles 56 are nozzles for atomizing liquid using a high-velocity flow of compressed air, and organic solvent supply ports 59 and inert gas supply ports 60 are connected thereto. As shown in Fig. 3, pipes 59a for supplying organic solvent are connected to the organic solvent supply ports 59. The pipes 59a are connected to the earth, and are composed of SUS piping that restricts elusion of metal ion into water or high-purification chemicals. The pipes 59a are provided with rubber heater 59b wrapped therearound as surface heat generating members.

The organic solvent supplied to the two-fluid nozzles 56 via the organic solvent supply ports 59 are selected from alcohols, ketones or ethers that are water-soluble and has a property to reduce surface tension of pure water with respect to the wafer 1 to promote drying up thereof. In this embodiment, IPA (Isopropyl alcohol) is employed, and is heated to a temperature of, for example, 40°C by the rubber heater 59b and delivered to the two-fluid nozzles 56. The inert gas to be supplied to the two-fluid nozzles 56 via the inert gas supply ports 60 is intended to be supplied simultaneously with IPA, which is organic solvent, for securing safety. In this embodiment, nitrogen gas (N2) is employed, and is heated to a temperature of, for example, 150°C by a heater (not shown) in advance and is supplied to the two-fluid nozzles 56. By the supply of high-temperature IPA and nitrogen gas to the two-fluid nozzles 56, the two-fluid nozzles 56 generate IPA mist. Heating of the organic solvent may be performed not only by the rubber heater 59a, but also by inserting the pipes 59a which are connected to the organic solvent supply ports 59 into the inert gas bath which is heated by the heater in advance and using the heat of the heated inert gas.

The IPA mist generated by the two-fluid nozzle 56 is maintained at a high temperature in itself and hence is vaporized from mist to vapor as IPA vapor simultaneously with injection from the nozzle, so that the IPA vapor is introduced into the cleaning bath 23. By the introduction of the IPA vapor onto the wafer 1 which is washed and rinsed in the cleaning bath 23, the wafer is exposed in the IPA vapor atmosphere in which water content attached on the front face 2 is liable to be evaporated, so that drying up of the front face 2 of the wafer 1 is promoted. The IPA vapor is introduced into the cleaning bath 23 after pure water as rinsing liquid is drained from the cleaning bath 23.

The gas supply unit 58 supplies nitrogen gas (N₂) at a room-temperature or a high-temperature into the cleaning bath 23 by turning on or off a heater, not shown. When the wafer has a hydrophobic property, nitrogen gas at the room temperature (the heater: off) is injected before generating the IPA vapor by the two-fluid nozzles 56, so that the wafer 1 having the hydrophobic property and having cleaned and rinsed in the cleaning bath 23 is exposed in the atmosphere of the nitrogen gas. In the course in which pure water as rinsing liquid is drained from the cleaning bath 23, the nitrogen gas at the room temperature described above is injected in to the cleaning bath 23 simultaneously with drainage.

Drying of the wafer 1 is quickly achieved by the supply of high-temperature inert gas heated by the heater (not shown), in this embodiment, high-temperature nitrogen gas (HOT N₂) from the above-describe gas supply unit 58 to the front face 2 of the wafer 1 in the IPA vapor atmosphere. When the high temperature nitrogen gas is introduced into the cleaning bath 23 from the gas supply unit 58, an excessive nitrogen gas is exhausted from the gas exhaust port 62 (Fig. 7, Fig. 13) provided on the lower part of the cleaning bath 23.

Reference numeral 64 in Fig. 7, Fig. 8 and Fig. 13 designates a gas exhaust port for exhausting unnecessary gas in the cleaning bath 23 when supplying cleaning liquid to the cleaning bath 23 and cleaning the wafer 1 in this cleaning bath 23, or when supplying rinsing liquid (pure water) to the cleaning bath 23 and rinsing the wafer in this cleaning bath 23. Reference numeral 65 designates a drain port for draining cleaning liquid or rinsing liquid (pure water) in the cleaning bath 23.

Reference numeral 57 in Fig. 3, Fig. 4, Fig. 7 and Fig. 13 is a nozzle for supplying pure water (pure water nozzle) for supplying pure water (DIW) to the inner surface of the device body 29 for regulating (cooling) the temperature in the cleaning bath 23 heated by the high-temperature drying fluid and cleaning the inside of the bath. The pure water nozzle 57 supplies pure water to the cleaning bath 23 in a state in which the front wall 28 of the cleaning device 11 is separated from the device body 29. Since it is necessary to perform cooling and cleaning without storing the pure water in the cleaning bath 23, it supplies pure water so as to flow along the inner surface of the device body 29 and the surface of the quartz plate 53 for cooling and cleaning the cleaning bath 23. Therefore, the pure water nozzle 57 is mounted so that the supply port thereof is in contact with the inner surface of the drive body 29 as shown in Fig. 3, Fig. 5 and Fig. 13. Pure water supplied to the cleaning bath 53 is drained through the drain port 65.

Reference numerals 86, 86 in Fig. 3 to Fig. 9 designate connecting port connected to a pipe 87 (shown only in Fig. 7) having a liquid level detection sensor 89 for detecting the liquid surface in the cleaning bath 23 (shown only in Fig. 7) provided thereon. The connecting port 85 is provided on the side surface of the cleaning bath 23 at a position corresponding to the first overflow bath 26, and the connecting ort 86 is provided on the side surface of the cleaning bath 23 below the cleaning liquid supply port 49, that is, a lower most portion of the cleaning bath 23. The liquid surface detection sensor 89 is composed of means that can confirm presence or absence of liquid in the pipe 87 such as a electrostatic capacity proximity sensor or the like, and is mounted to the pipe 87 connected to the connecting ports 85, 86 and extended in the vertical direction. More specifically, it is mounted to a position corresponding to the lower end of a recess 47 provided on the wafer holding device 24 at the lowermost position. Accordingly, when the rinsing liquid is drained after rinsing operation is ended and the procedure moves to the drying process, the fact that the level of the rinsing liquid is lowered to a level lower than the lower end of the recess 47 at the lowermost position of the wafer holding device 24 is determined, so that the wafer holding device 24 can be proceeded into the opening 30 on the front wall 28 to hold the rear face 3 of the wafer, and hence the rinsing liquid flowing out from the cleaning bath 23 via the annular clearance 72 at the time of drainage can be prevented from entering into the recess 47 formed on the inner side of the distal end of the recess 47.

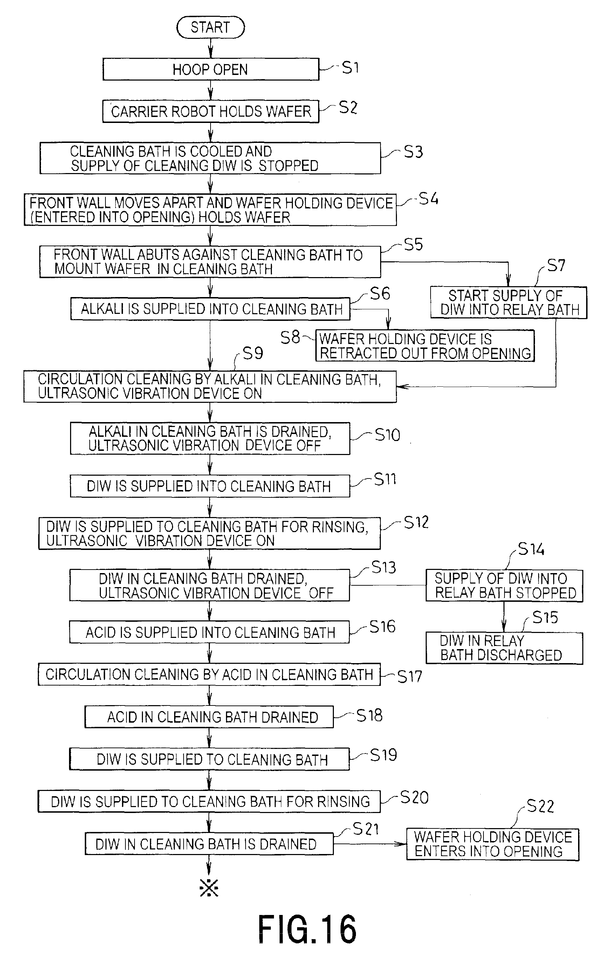

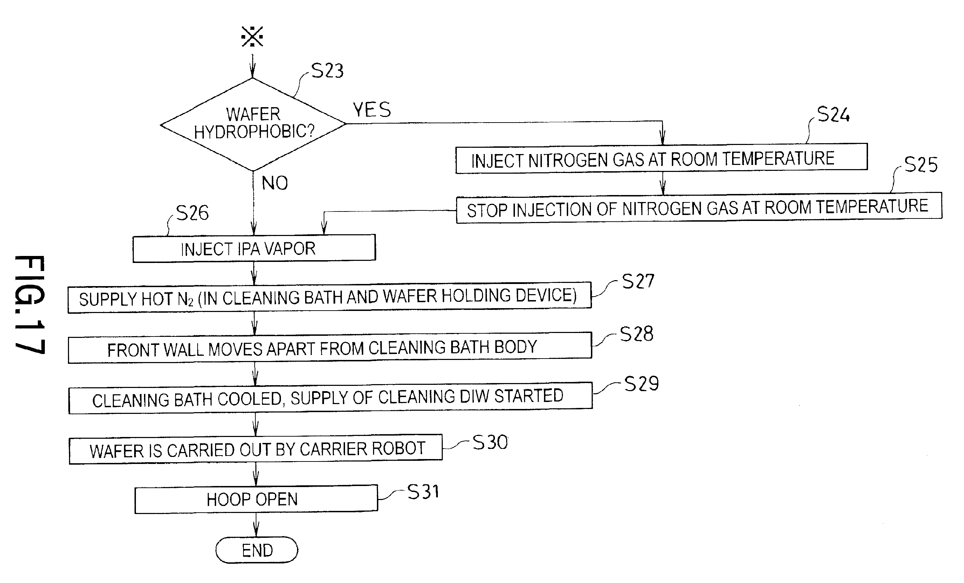

Referring now to Fig. 16 and Fig. 17, the operation of the above-described cleaning device 11 will be described.

The cleaning device includes: a carrying-in process (S1 to S5) for carrying the wafer 1 into the cleaning bath 23 by the carrier robot 15, exposing the front face 2 of the wafer 1 into the cleaning bath 23 and the rear face 3 of the wafer 1 out of the cleaning bath 23, providing the annular clearance 72 between the wafer 1 and the front wall 28, and mounting the wafer 1 to the cleaning bath 23; a cleaning and rinsing process (S6 to S22) for causing cleaning liquid to flow in the cleaning bath 23, cleaning and rinsing the front face 2 of the wafer 1 that is in contact with the cleaning liquid, and rinsing the rear face 3 of the wafer 1 by cleaning liquid or rinsing liquid flowing out from the annular clearance 72 by the action of the pressure (water pressure) of the cleaning liquid or the rinsing liquid in the cleaning bath 23; a drying process (S23-S27) for introducing IPA vapor, pure water mist and high-temperature nitrogen gas into the cleaning bath 23 in a state in which the wafer 1 is mounted to the cleaning bath 23 after having finished the washing and rinsing process, and drying the wafer 1, and a wafer carrying-out process (S28 to S31) for carrying out the wafer 1 after having cleaned, rinsed, and dried out of the cleaning bath 23 by the carrier robot 15. These processes are described further in detail.

As shown in Fig. 1, in the carry-in process for carrying in the wafer, a wafer carrier container (so-called hoop) of the wafer supply/discharge section 14 of the cleaning facility 10 is first opened by a container opener (S1), and the hand section 20D of the carrier robot 15 holds the front face 2 of the wafer 1 in the wafer carrier container 17 in a non-contact state (S2). Then, supply of pure water being supplied into the cleaning bath 23 from the pure water nozzle 57 in Step 29 described later is stopped (S3). In other words, supply of pure water, which is supplied to the surface of the device body and the quartz plate 53 from the pure water nozzle 57 for regulating (cooling) the temperature in the cleaning bath 23 heated by the high-temperature drying fluid in the drying process for a wafer immediately preceding the wafer 1 being currently processed and cleaning the inside of the bath, is stopped for mounting the waver 1 into the cleaning layer 23.

Subsequently, as shown in Fig. 4 to Fig. 6, the front wall 28 of the cleaning device 11 in the cleaning device layout section 12 is moved apart form the device body 29, and the wafer holding device 24 inserted and positioned in the opening 30 on the front wall 28 holds the rear face 3 of the wafer 1 held by the hand section 20D of the carrier robot 15 in the non-contact state and receives the wafer 1 form the carrier robot 15 (S4). In this state, the wafer 1 comes into contact with the pins 71 of the front wall 28, and hence the annular clearance 72 is defined between the wafer 1 and the circumference of the opening 30 of the front wall 28 and, as shown in Fig. 7 and Fig. 8, the front wall 28 continuously abuts against the device body 29 to configure the cleaning bath 23 and, simultaneously, the wafer 1 is mounted in the cleaning bath 23 (S5).

As shown in Fig. 9 and Fig. 13, in the cleaning and rinsing process, alkaline cleaning liquid is supplied from the cleaning liquid supply port 49 into the cleaning bath 23 (S6) and pure water is supplied from the relay bath supply/drain port 54 into the relay bath 52 (S7). At the time of starting the supply of the alkaline cleaning liquid, the wafer holding device 24 is retracted out from the opening 30 of the front wall 28 by the retracting operation of the holding device cylinder 78, and the rear face 3 of the wafer 1 comes into contact with and held by the pins 71 by the pressure (hydraulic pressure) of the alkaline cleaning liquid in the cleaning bath 23 (S8), and then the wafer 1 is supported by the receiving member 72 and the gas exhaust port 64 is opened.

The alkaline cleaning liquid flows from the cleaning liquid supply port 49 toward the first overflow bath 26 in the cleaning bath 23, part of the alkaline cleaning liquid flows out of the cleaning bath 23 from the annular clearance 72, and reaches the drainage bath 75 via the second overflow bath 80, while most part of the alkaline cleaning liquid in the cleaning reaches the drainage bath 75 via the first overflow bath 26. The alkaline cleaning liquid in the discharge bath 75 is filtered and returned into the cleaning bath 23 via the cleaning liquid supply port 49. During this period, fresh pure water flows from the relay bath supply/drain port 54 toward the relay bath overflow port 55 in the relay bath 52. While pure water flows in the relay bath 52, the ultrasonic vibration device 25 is activated to clean the front face 2 and the rear face 3 of the wafer 1 by the ultrasonic wave and the alkaline cleaning liquid (S9). In this case, the end surface of the wafer 1 is also cleaned in the process in which the alkaline cleaning liquid flows out from the cleaning bath 23 via the annular clearance 72 to clean the rear face 3 of the wafer.

After having finished the alkaline cleaning, the alkaline cleaning liquid in the cleaning bath 23 is discharged via the drain port 65, the ultrasonic vibration device 25 is stopped (S10), and the alkaline cleaning liquid is drained from the cleaning bath 23. In this case, the cleaning liquid in the cleaning bath 23 is discharged, and hence is not stored therein, the cleaning liquid remains at the contact points between the pins 71 on the front wall 28 and the rear face 3 of the wafer 1, and hence the peripheral edge portion of the rear face 3 comes in contact with the pins 71 and the wafer 1 is held in the vertically upright position by the surface tension thereof. After having drained the alkaline cleaning liquid, pure water (DIW) as rinsing liquid is introduced into the leaning bath 23 via the cleaning liquid supply port 49 (S11). The rear surface 3 of the wafer 1 comes into contact with the pin 71, and the wafer 1 is supported by the receiving member 73.

The ultrasonic vibration device 25 is activated while the rinsing liquid flows from the cleaning liquid supply port 49 toward the first overflow bath 26 in the cleaning bath 23, and then flows out from the annular clearance 72, and the front face 2 and the rear face 3 of the wafer 1 are rinsed by rinsing liquid (S12). At the time of rinsing, the rinsing liquid discharged from the first overflow bath 26 and the second overflow bath 80 via the drainage bath 75 is discarded, and fresh rinsing liquid (pure water) is supplied from the cleaning liquid supply port 49 to the cleaning bath 23.

After having finished the rinsing operation, the ultrasonic vibration device 25 is stopped, and the rinsing liquid is drained from the cleaning bath 23 via the drain port 65 (S13). In this case, by the rinsing liquid remained at the contact points between the pins 71 on the front wall 28 and the rear face 3 of the wafer 1, the peripheral edge portion of the rear face 3 comes in contact with the pins 71 and the wafer 1 is held in the vertically upright position by the surface tension thereof. Simultaneously with stop of the ultrasonic vibration device 25, supply of pure water into the relay bath 52 is stopped (S14), and the pure water in the relay bath 52 is discharged via the cleaning liquid supply port 49 (S16).

Subsequently, acid cleaning liquid is supplied from the cleaning liquid supply port 49 into the cleaning bath 23 (S16). Accordingly, the rear face 3 of the wafer 1 is held in contact with the pins 71 by the pressure (hydraulic pressure) of acid cleaning liquid in the cleaning bath 23, and the wafer 1 is supported by the receiving member 73. The acid cleaning liquid flow from the cleaning liquid supply port 49 toward the first overflow bath 26 in the cleaning bath 23, and part of the acid cleaning liquid flow out from the cleaning bath through the annular clearance 72, and reaches the drainage bath 75 via the second overflow bath 80, while most part of the acid cleaning liquid in the cleaning baht 23 reaches the drainage bath 75 via the first overflow bath 26. The acid cleaning liquid in the drainage bath 75 is filtered, and returned into the cleaning bath 23 via the cleaning liquid supply port 49. In this manner, the circulating acid cleaning liquid cleans the front face 2 and the rear face 3 of the wafer 1 (S17). In this case, the end surface of the wafer 1 is also cleaned in the course in which the acid cleaning liquid flows out from the cleaning bath 23 via the annular clearance 72 to clean the rear face 3 of the wafer 1.

After having finished the acid cleaning, the acid cleaning liquid in the cleaning bath 23 is discharged via the drain port 65 (S18). In this case, since the cleaning liquid remains at contact points between the pins 71 on the front wall 28 and the rear face 3 of the wafer 1, the peripheral edge portion of the rear face 3 of the wafer comes into contact with the pins 71 and the wafer 1 is held in the vertically upright position by the surface tension thereof. After having drained the acid cleaning liquid from the cleaning bath 23, pure water (DIW) as rinsing liquid is supplied into the cleaning bath 23 (S19). Accordingly, the rear face 3 of the wafer 1 comes into contact with the pins 71 and held by the pressure (hydraulic pressure) of the rinsing liquid, and the wafer 1 is supported by the receiving member 73.

The rinsing liquid rinses the front face 2 and the rear face 3 of the wafer 1 while flowing from the cleaning liquid supply port 49 toward the first overflow bath 26 in the cleaning bath 23, and flowing out from the annular clearance 72 (S20). In this case, the end surface of the wafer 1 is also rinsed in the process in which the rinsing liquid flows out from the cleaning bath 23 through the annular clearance and rinses the rear face 3 of the wafer 1. At the time of rinsing, the rinsing liquid discharged from the first overflow bath 26 and the second overflow bath 80 via the drainage bath 75 is discarded, and fresh rinsing liquid (pure water) is supplied from the cleaning liquid supply port 49 to the cleaning bath 23.

After having finished the rinsing operation, the rinsing liquid is drained from the cleaning bath 23 via the drain port 65 (S21). When draining the rinsing liquid, the fact that the level of the rinsing liquid is lowered to a level lower than the lower end of the recess 47 at the lowermost position of the wafer holding device 24 is determined, that is, the fact that there is no rinsing liquid existing above the liquid level detection sensor 89 is detected, so that the wafer holding device 24 can be proceeded into the opening 30 on the front wall 28 to cause the rear face 3 of the wafer 1 to come into contact with the pins 71 by the wafer holding device 24 as shown in Fig. 7 and Fig. 8 (S22).

When the rear face 3 of the wafer 1 is held by the wafer holding device 24 in S22, if the wafer 1 has a hydrophobic property, nitrogen gas at the room temperature is injected from the gas supply unit 58 of the drying fluid supply bath 27 into the cleaning bath 23 (S24). Exposing the hydrophobic wafer 1 in the atmosphere of nitrogen gas at the room temperature is intended to make the IPA vapor injected into the cleaning bath 23 conform to the wafer 1 easily in the next process. Then, after a predetermined time has elapsed from the start of injection of nitrogen gas at the room temperature from the gas supply unit 58, injection of nitrogen gas at the room temperature is stopped (S25) and the procedure goes to a step of injecting IPA vapors described below.

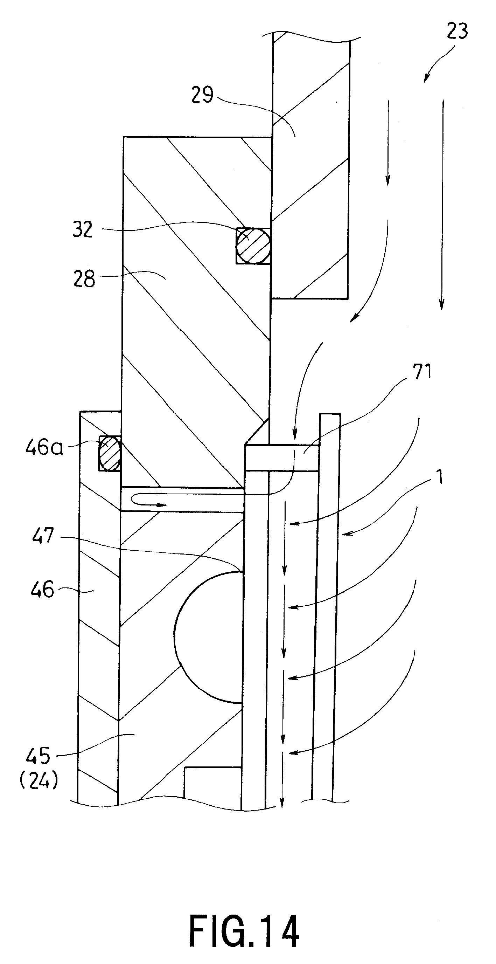

After having drained rinsing liquid (pure water) in Step S20, if the wafer 1 dose not have a hydrophobic property in Step S23, IPA vapor is injected from the two-fluid nozzle 56 in the drying fluid supply bath 27 after having drained the rinsing liquid from the cleaning bath 23 through the drain port 56 (S26). Before starting injection of IPA vapor, the gas exhaust port 64 is closed. By the IPA vapor being introduced into the cleaning bath 23, the interior of the cleaning bath 23 is exposed in the IPA atmosphere, and hence drying by the high-temperature nitrogen gas in the next step (S27) is more likely promoted. In this case, as shown in Fig. 1 to Fig. 14, since the cover 46 of the wafer holding device 24 comes into abutment with the front wall 28 and the sealing member 46a of the cover 46 comes into tight contact with the front wall 28, a sealing property between the cover 46 and the front wall 28 is favorably secured and, as shown in Fig. 14, the cover prevents IPA vapor from being diffused from the clearance between the front wall 28 and the wafer holding device 24, and hence the rear face of the wafer 1 is also exposed in the IPA vapor atmosphere. Accordingly, drying by the high-temperature nitrogen gas in the next step (S27) is more likely promoted also in the rear face of the wafer 1.

After having finished the supply of the IPA vapor, the high-temperature nitrogen gas (HOT N₂) is supplied from the gas supply unit 58 in the drying fluid supply bath 27 into the cleaning bath 23, and the front face 3 and the rear face 3 of the wafer 1 is quickly dried (S27). When drying the wafer 1 by the high-temperature nitrogen gas, the high-temperature nitrogen gas is mixed with gas that is introduced into the wafer holding device 24 and forms whirling flow in the recess 47, and hence the wafer 1 held by the wafer holding device in the non-contact state is heated also from the rear face. In addition, by the injection of the high-temperature nitrogen gas from the drying fluid supply port 48 provided inside of the wafer holding device at a center thereof, drying of the wafer 1 is further promoted. When drying with the high-temperature nitrogen gas, the gas exhaust port 72 (Fig. 7) is opened, so that the nitrogen gas is exhaust from the cleaning bath 23.

After having finished the drying process described above, the procedure goes to a carrying-out process for carrying out the wafer 1, where the front wall 28 of the cleaning device 1 moves apart from the device body 29 (S28). Then, in the drying process, the temperature in the cleaning bath 23 heated by the high-temperature drying fluid is regulated (cooled), the interior of the bath is cleaned, pure water is supplied from the pure water nozzle 57 so as to flow along the surfaces of the device body 29 to cool down and clean the interior of the cleaning bath 23 for a subsequent wafer (S29). Pure ware supplied into the cleaning bath 23 is drained via the drain port 65. Supply of pure water from the pure water nozzle 57 is continued until the process of the current wafer 1 is finished and, in the process for a subsequent wafer 1 to be carried from the wafer carrier container 17, the front wall 28 of the cleaning device 11 moves apart from the device body 29 and the wafer holding device 24 receives the wafer 1 from the carrier robot 15 in the non-contact state (stop of supply of pure water: S3). Then, as shown in Fig. 5, the hand section 20D of the carrier robot 15 enters between the front wall 28 and the device body 29, and holds the front face 2 of the wafer 1 in a non-contact state, whereby the wafer 1 is received from the wafer holding device 24 of the cleaning device 11 (S30). The carrier robot 15 stores the received wafer 1 into the wafer carrier container 17 when the wafer carrier container 17 (hoop) in the wafer supply/discharge section is opened (S31).

In this arrangement, according to the embodiment described above, the following advantages (1) to (14) are achieved.
(1) The front wall 28 that configure the cleaning bath 23 by abutting against the device body 29 is provided with the opening 30 corresponding to the contour of the wafer 1, the wafer holding device 24 can hold the rear face 3 of the wafer 1 carried inside the front wall 28 through the opening 39 from the outside of the front wall 28 to bring the wafer 1 into the vertically upright position, and the annular clearance 72 is formed between the wafer 1 and the circumference of the opening 30 by the pins 71 provided along the circumference of the opening 30 in the inner surface of the front wall 28 being in contact with the rear face 3 of the wafer. Therefore, when the cleaning liquid or the rinsing liquid is supplied into the cleaning bath 23, the front race 2 of he wafer 1 is cleaned or rinsed by the cleaning liquid or the rinsing liquid in the cleaning bath 23, and the cleaning liquid or the rinsing liquid flowed out through the annular clearance 72 defined by the pins 71 cleans or rinses the rear face of the wafer by the action of the pressure (hydraulic pressure) of the cleaning liquid or the rinsing liquid in the cleaning bath 23. Consequently, the front face 2 and the rear face 3 of the wafer 1 can be cleaned or rinsed simultaneously. The end surface of the wafer 1 can also be cleaned or rinsed in the process that the cleaning liquid or the rinsing liquid flows out of the cleaning bath 23 through the annular clearance 72 and cleans the rear face 3 of the wafer 1.
(2) Since the cleaning liquid or the rinsing liquid having been used for cleaning or rinsing the rear face 3 of the wafer 1 does not flow into the cleaning bath 23 by the action of the pressure (hydraulic pressure) of the cleaning liquid or the rinsing liquid in the cleaning bath 23, the transfer contamination on the front face 2 of the wafer 1 due to cleaning liquid that has cleaned or rinsed the rear face is reliably prevented.
(3) The annular clearance 72 between the circumference of the opening 30 on the front wall 28 and the wafer 1 disposed in the vertically upright position is set to be wider on the upper part than the lower part. Therefore, the amount of the cleaning liquid or the rinsing liquid in the cleaning bath 23 flowing out from the lower part of the annular clearance 72 can be restricted, and hence the cleaning liquid or the rinsing liquid can be stored easily in the cleaning bath 23. In addition, by setting the upper part of the annular clearance 72 to be wider, the amount of cleaning liquid or the rinsing liquid flowing out from the upper part is increased, and hence the entire back face 3 of the wafer 1 can be cleaned and rinsed uniformly.
(4) Since the cleaning device 11 is provided with the ultrasonic transducer 51 of the ultrasonic vibration device and the quartz plate 53 opposed to the wafer 1 substantially in substantially parallel thereto, the ultrasonic wave generated by the ultrasonic vibration device 25 acts uniformly and entirely on the front face 2 and the rear face 3 of the wafer 1, and hence the front face 2 and the rear face 3 of the wafer 1 can be cleaned uniformly and favorably.
(5) Since the rear face 3 of the wafer 1 is held by the wafer holding device 24 in the non-contact state, the rear face 3 of the wafer 1 is prevented from being contaminated by being held by the wafer holding device 24, and such prevention of contamination can be achieved also on the end surface of the wafer 1, which was difficult to clean since the chuck or the like is in contact thereto.
(6) The wafer holding device 24 is installed on the front wall 28 via the mounting plate 77, the side plate 79 and the holding device cylinder 78 so as to be capable of moving relatively with respect to the front wall 28 in the axial direction 30R of the opening 30, and is adapted to be retracted from the wafer and release the wafer 1 from the moment when the cleaning is started until the drying process is started. Therefore, the wafer 1 is held by the pressure (hydraulic pressure) of the cleaning liquid or the rising liquid when the cleaning liquid or the rinsing liquid is supplied into the cleaning bath 23, and otherwise, the wafer 1 is held by the wafer holding device 24 in the non-contact state, so that contamination is prevented in either cases. The end surface of the wafer 1, which was difficult to clean since the shuck or the like is in contact thereto can also be prevented from being contaminated.
(7) Since the receiving member 73 installed on the front wall 28 supports the wafer 1 by a point-contact state, contamination that occurs when the wafer 1 is supported by the receiving member 73 can be minimized.
(8) Since the cleaning liquid filtered by the filter installed on the outside of the cleaning bath 23 is circulated and supplied into the cleaning bath 23, the amount of consumption of the cleaning liquid by repeated usage thereof, and the temperature control of the cleaning liquid can be achieved easily only by measuring and maintaining the temperature of the circulating cleaning liquid.
(9) Since the wafer 1 is arranged in the cleaning bath 23 in the vertically upright position, reduction of space required for the cleaning bath 23 and hence for the entire cleaning device 11 is achieved, and changes in diametrical size of the wafer 1 can be accommodated easily by selecting the wafer holding device 24 having an outer diameter corresponding to the size of the wafer 1 and selecting the front wall 28 with an opening 30 having a diameter corresponding to the wafer 1.
(10) Since the wafer 1 is mounted to the cleaning bath 23 at a standstill in a state in which the peripheral edge of the rear face 3 of the wafer 1 is in contact with the pins 71 on the circumference of the opening 30 on the inner surface of the front wall 28, thereby defining the annular clearance 72, a rotary mechanism does not exist in the cleaning device 11. Therefore, the number of components in the cleaning device 11 can be reduced, and complicated adjustment of the rotary mechanism is not necessary. In addition, supply of the cleaning liquid or the like into the cleaning device 11 or discharge of the unnecessary gas can be performed easily without considering the influence of the air stream generated by the rotary mechanism.
(11) Since the cleaning bath 23 is provided with the drying fluid supply tank 27 for introducing drying fluid (for example, IPA vapor, pure water mist, high-temperature nitrogen gas) into the cleaning bath 23 so as to be continued therefrom, the wafer 1 can be dried by the above described drying fluid from the drying fluid supply bath 27 in as state in which the wafer is mounted in the cleaning bath 23. Therefore, the cleaning and rinsing process and the drying process can be performed consecutively and quickly.
(12) Since the temperatures of the high-temperature IPA and nitrogen gas supplied to the two-fluid nozzles 56 are temperatures at which the fluid can be vaporized simultaneously with injection of the fluid from the two-fluid nozzles 56, the displacement efficiency of water content attached on the target object is increased in comparison with the injection of the fluid, and not only the amount of injection of the IPA and nitrogen gas, but also the amount of drainage can be reduced.
(13) Since the IPA is heated by the rubber heaters 59 wrapped around the pipes 59a, the IPA can be heated in a simple structure. In addition, by composing the pipes 59a of SUS piping that restricts elusion of metal ion into water or high-purification chemicals, electro-static charge is prevented, and hence explosion proof is easily achieved for the combustible IPA.
(14) Since the interior of the cleaning bath 23 is brought into the IPA atmosphere by using the IPA vapor as a fluid to promote drying up so that drying in the next step is more likely promoted, and then the IPA attached to the wafer 1 is vaporized and dried quickly with the heated nitrogen gas in the next step, water contents attached to the front face 2 of the wafer 1 can be dried reliably and quickly. In addition, by using the nitrogen gas, the atmosphere of the inert gas is established and oxygen is eliminated from the cleaning bath 23, generation of watermarks is prevented.

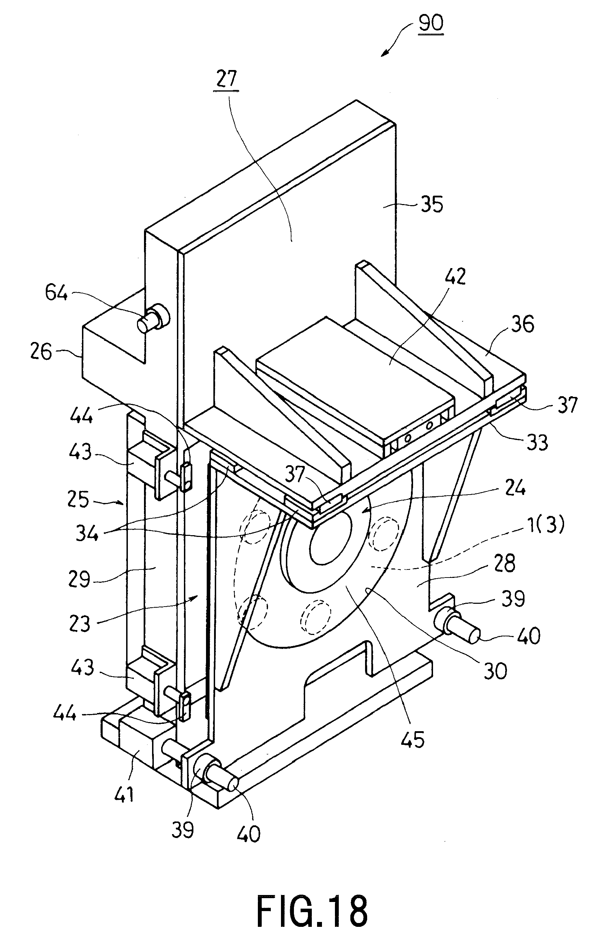

### B. Second Embodiment (Fig. 18 to Fig. 23)

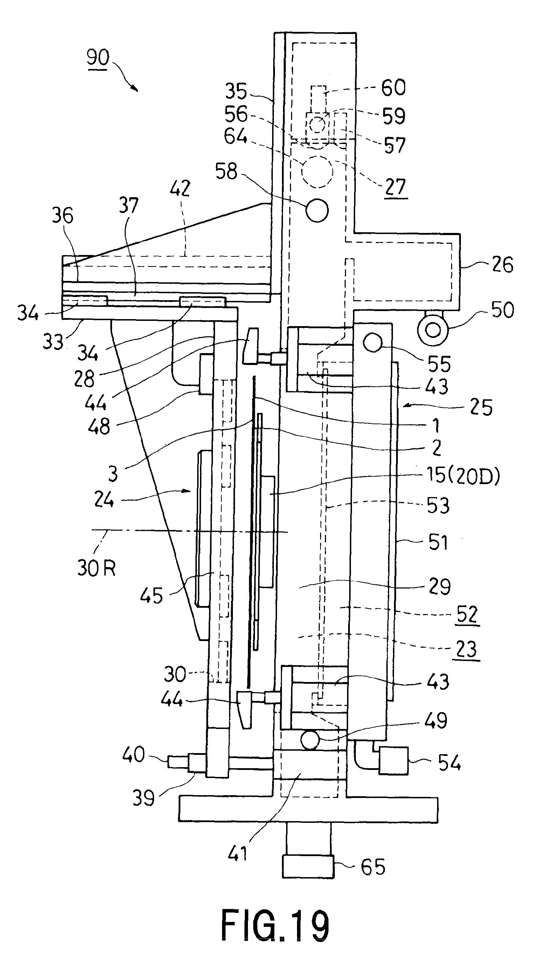

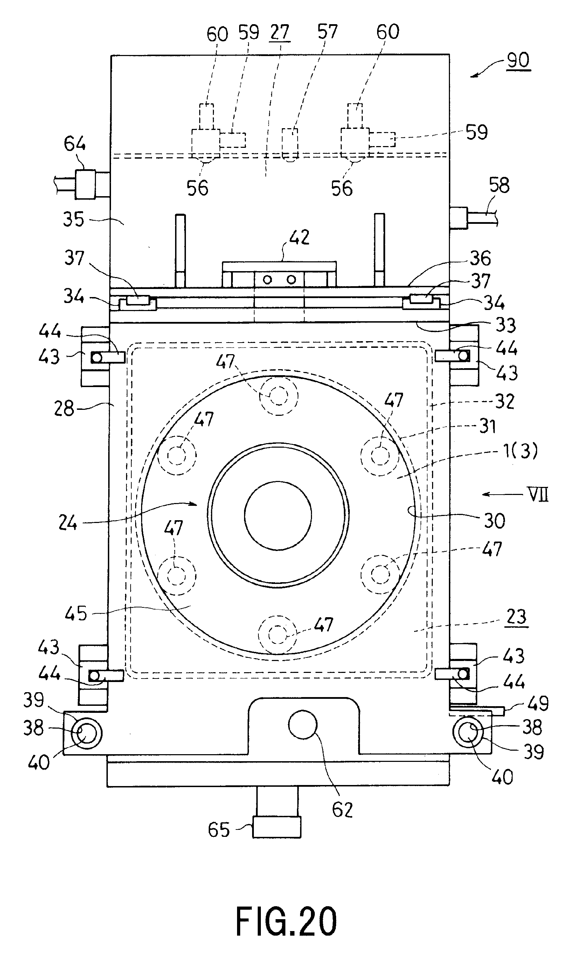

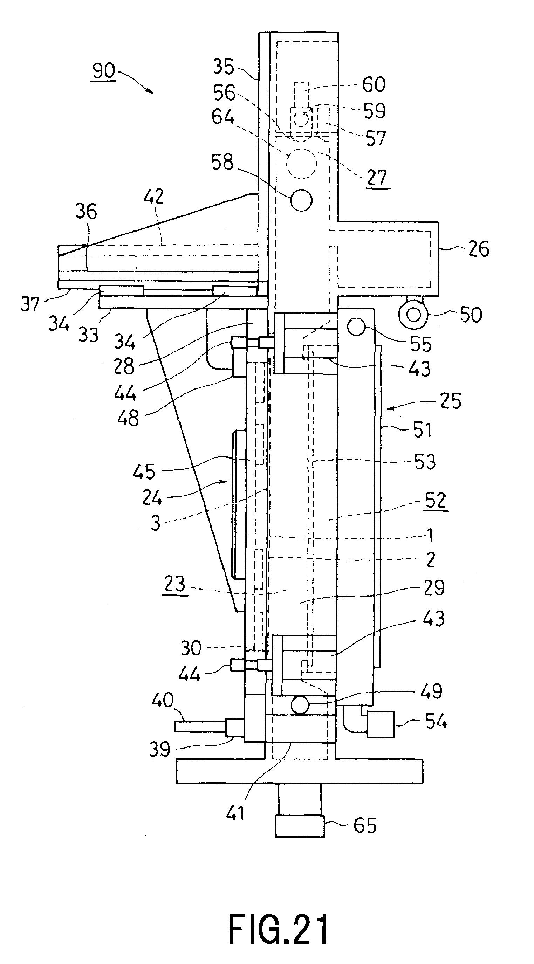

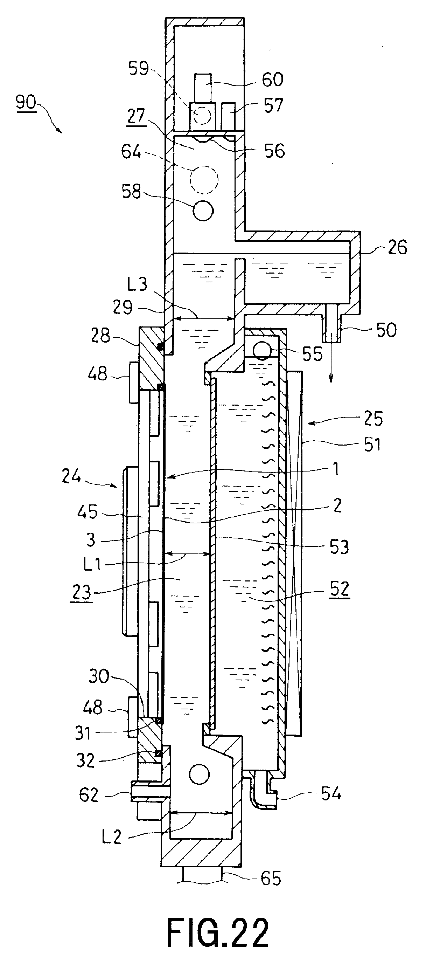

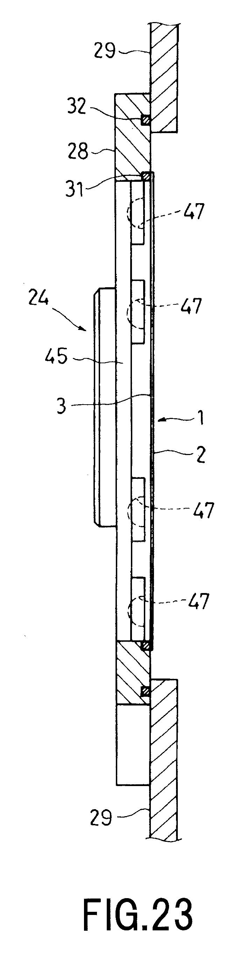

Fig. 18 is a perspective view of a cleaning device in a waiting state according to a second embodiment the invention viewed obliquely from the front. Fig. 19 is a side view of the cleaning device in Fig. 18 in a state of carrying in and out the wafer. Fig. 20 is a front view of the cleaning device in a state in which the wafer is in the process of being cleaned. Fig. 21 is a drawing of the cleaning device viewed in the direction indicated by an arrow VII in Fig. 20. Fig. 22 is a cross-sectional view showing a schematic structure for explaining the principle of the cleaning device shown in Fig. 18. Fig. 23 is a cross-sectional view showing part of Fig. 22 in an enlarged scale. In the second embodiment, description of the same parts as in the first embodiment will be omitted by allocating the same reference numerals.

In a cleaning device 90 according to the second embodiment, the counter sunk surface 70 formed along the circumference of the opening 30 on the front wall 28 and the pins 71 which is implanted in the counter sunk surface 70 as the clearance defining member do not exist, and hence the annular clearance does not exist, so that the peripheral edge of the rear face 3 of the wafer 1 comes into tight contact with the front wall 28. Since the peripheral edge of the rear face 3 of the wafer 1 comes into tight contact with the front wall 28 and closes the opening 30 of the front wall 28, cleaning liquid or rinsing liquid does not flow out of the cleaning bath 23. Therefore, it is configured into a one-side cleaning/rinsing structure in which only the front face of he wafer 1 is cleaned or rinsed, and hence the rear face 2 is not cleaned or rinsed. Since the cleaning liquid or the rinsing liquid does not flow out to the rear face 3 side of the wafer 1 from the cleaning bath 23, it is not necessary to retract the wafer holding device 24 from the front wall, so that the front wall 28 and the wafer holding device 24 are joined and hence may be moved integrally.

More specifically, the cleaning bath 23 is formed into a flat box-shape defined by the front wall 28 as one side wall which abuts against the device body 29 other than the front wall 28, and the front wall 28 is formed with the opening 30 having a shape corresponding to the contour of the wafer 1. The seal member 31 such as an O-ring (Fig. 20 and Fig. 22) is disposed along the circumference of the opening 30 on the inner surface of the front wall 28. A seal member 32 is disposed on the inner surface of the front wall 28 at a position that can abut against the device body 29 on the outside of the seal member 31.

As shown in Fig. 19 and Fig. 22, the wafer holding device 24 is joined with the front wall 28 in a state of being positioned in the opening 30 of the front wall 28, and is capable of moving integrally with the front wall 28. Therefore, when the front wall 28 is moved apart from the device body 29, the hand section 20D of the carrier robot 15 holds the front face 2 of the wafer 1 in the non-contact state and enters between the front wall 28 and the device body 29. At this time, the wafer holding device 24 holds the rear face 3 of the wafer 1 in the non-contact state through the opening 30 from the outside of the front wall 28 by the action of the negative pressure, and the wafer 1 is transferred to the wafer holding device 24 and carried into the cleaning bath 23 in the cleaning device 90. After the wafer 1 is carried into the cleaning bath 23, the front wall 28 comes into abutment against the device body 29 and hence the cleaning bath 23 is configured as shown in Fig. 21 and Fig. 22.

By the rear face 3 of the wafer 1 being held by the wafer holding device 24 in the non-contact state, the wafer 1 is mounted to the cleaning bath 23 in a state of being oriented vertically upright in the cleaning bath 23 and closing the opening 30 on the front wall 28 by the peripheral edge of the rear face 3 thereof, which comes into tight contact with the seal member 31 on the front wall 28, with the front face 2 being exposed in the cleaning bath 23 and the rear face 3 being exposed to the outside of the cleaning bath 23. The cleaning bath 23 is secured in a liquid-tight state by the peripheral edge of the rear face 3 of the wafer 1 being in tight contact with the seal member 31 of the front wall 28 and the seal member 32 on the front wall 28 being in tight contact with the device body 29. In a state in which the cleaning bath 23 is filled with fluid such as cleaning liquid, the peripheral edge of the rear face 3 of the wafer 1 comes into tight contact with the sealing member 31 of the front wall 28 by the hydraulic pressure of the fluid with respect to the wafer. Therefore, the liquid-tight state is secured even when the wafer holding device 24 is not activated. By the front face 2 of the wafer 1 being exposed into the cleaning bath 23 and the rear face 3 thereof being exposed to the outside of the cleaning bath 23, the front face 2 of the wafer 1 comes into contact with the cleaning liquid in the cleaning bath 23, and the back surface 3 of the wafer 1 does not come into contact therewith.

By the supply of the high-frequency signal from the high-frequency oscillator to the ultrasonic transducer 51, the ultrasonic transducer 51 causes ultrasonic vibrations, and the ultrasonic vibrations is irradiated on the front face 2 of the wafer 1 mounted to the cleaning bath 23 via the pure water in the relay bath 52 and the quartz plate 53, whereby cleaning only of the front face 2 is performed. In this case, since the cleaning is performed in a state in which the peripheral edge of the rear face 3 of the wafer 1 is in tight-contact with the seal member 31 of the front wall 28, the end surface of the wafer 1 is also cleaned.

Since other configurations are the same as in the first embodiment, this embodiment achieves not only the effects of the first embodiment (5), (8), (9) and (11) to (14), but also the following effects (15) to (16).
(15) The cleaning bath 23 is configured by abutment of the front wall 28 against the device body 29 in the cleaning device 90, the opening 30 if formed on the front wall 28 of the cleaning both 23, the wafer holding device holds the rear face 3 of the wafer 1 in the non-contact state through the opening 30 from the outside of the cleaning bath 23, the wafer 1 is held in the vertically upright position by the hydraulic pressure by the wafer holding device 24, and the peripheral edge of the rear face 3 of the wafer 1 closes the opening 30 by being in tight contact with the seal member 31 on the circumference of the opening 30 on the inner surface of the front wall 28 by the wafer holding device 24 and the hydraulic pressure, so that the wafer is mounted with the front face 2 exposed into the cleaning bath 23 and the rear face 3 exposed to the outside of the cleaning bath 3, the cleaning liquid comes into contact with the front surface and the cleaning liquid does not come in contact with the rear face 3, the transfer contamination on the front face of the wafer 1 due to dirt on the back face 3 of the wafer running up to the front face 2 side is reliably prevented. Since the cleaning is performed in a state in which the peripheral edge of the rear face 3 of the wafer 1 is cleaned in a state of being in tight contact with the sealing member 31, the end surface of the wafer 1 can be cleaned as well.
(16) Since the ultrasonic transducer 51 of the ultrasonic vibration device 25 and the quartz plate 53 are arranged in the cleaning device 90 so as to oppose to the wafer in parallel therewith, the ultrasonic wave generated by the ultrasonic vibration device 25 acts entirely and uniformly on the front face 2 of the wafer 2, the front face 2 of the wafer 1 can be cleaned uniformly and favorably.

Although the invention has been described on the basis of the embodiments, the invention is not limited thereto.

In the embodiments shown above, a configuration in which the wafer 1 is held in the vertically upright position by the surface tension of the residual liquid such as cleaning liquid at the contact points between the pins 71 on the front wall 28 and the rear face 3 of the wafer 1 when draining the cleaning liquid or the rinsing liquid from the cleaning bath 23 has been described. However, it is also possible to ensure the non-contact holding by a configuration such that the wafer holding device 24 enters into the opening 30 of the front wall 28 by the action of the holding device cylinder 78 at every drainage to hold the rear face 3 of the wafer 1.

Although the configuration in which the wafer holding device 24 of the cleaning device 11 holds the rear face 3 of the wafer 1 in the non-contact state by the action of the negative pressure generated by the whirling flow. However, in the embodiments shown above, it is also possible to configure in such a manner that a suction holding device for sucking the pins 71 provided on the front wall 28 under substantial vacuum is provided, whereby the peripheral edge of the rear face 3 of the wafer 1 positioned inside the front wall 28 by the hand section 20D of the carrier robot 15 is adsorbed to the pins 71 so that the wafer 1 is mounted to the front wall 28. In this case, since the wafer holding device 24 and the holding device cylinder 78 can be omitted, the structure of the cleaning device 11 can be simplified, and the operation of the cleaning device 11 can be facilitated.

In the second embodiment, the wafer 1 may be mounted to the front wheel by providing the suction holding device for sucking the wafer 1 positioned inside the front wall 28 by the hand section 20D of the carrier robot 15 together with the front wall 28 from the outside of the front wall 28 under substantial vacuum, thereby bringing the peripheral edge of the rear face 3 of the wafer 1 into tight contact with the seal member 31 on the inner surface of the front wall 28. In this case as well, the suction holding device and he rear face 3 of the wafer 1 is in the non-contact state, the rear face 3 of the wafer 1 is prevented from being contaminated by the suction holding device.

In the embodiments shown above, the device according to the invention is described as the cleaning device, it is also possible to use the device in the invention as a drying device with the provision of the cleaning bath 23 and the drying bath. In this case, since the wafer 1 can be dried in the vertically upright position by the wafer holding device 24, reduction of the space required for the drying bath, and hence the space required for the entire drying device can be achieved.

In summary, an embodiment of the invention can be described as follows:

The invention provides a cleaning device for cleaning or rinsing a wafer disposed in a cleaning bath by cleaning fluid in the cleaning bath including a front wall that configures the cleaning bath by being in abutment with a device body and is formed with an opening corresponding to a contour of the target object; a wafer holding device being capable of holding a rear face of the target object carried into the inner side of the one side wall through the opening from the outside of the one side wall and holding the target object in a vertically upright position; and a pins provided on a circumference of the opening on an inner surface of the one side wall for defining a clearance between the wafer and the circumference of the opening by being in contact with the rear face of the target object.

## Claims

1. A cleaning device for cleaning or rinsing a target object disposed in a cleaning bath by cleaning fluid in the cleaning bath comprising:
one side wall that configures the cleaning bath by being in abutment with a device body and is formed with an opening corresponding to a contour of the target object;
holding means being capable of holding a rear face of the target object carried into the inner side of the one side wall through the opening from the outside of the one side wall and holding the target object in a vertically upright position; and
a clearance defining member provided on a circumference of the opening on an inner surface of the one side wall for defining a clearance between the target object and the circumference of the opening by being in contact with the rear face of the target object.

2. The cleaning device according to Claim 1, wherein the clearance between the circumference of the opening on the one side wall and the target object disposed in vertically upright position is set to be wider on the upper part then the lower part.

3. The cleaning device according to **any of the preceding claims, wherein the** cleaning device includes an ultrasonic vibration device arranged so as to oppose to and in parallel with the target object.

4. The cleaning device according to **any of the preceding claims, wherein** the one side wall is configured to be movable in an axial direction of the opening with respect to the device body, the target object is carried in and held by the holding means when the one side wall moves apart from the device body, and the cleaning bath is configured by abutment between the one side wall and the device body.

5. The cleaning device according to Claim 4, wherein the holding means hold the rear face of the target object in a non-contact state by the action of a negative pressure generated by a whirling flow.

6. The cleaning device according to Claim 5, wherein the holding means is installed on the one side wall so as to be capable of moving relatively with respect to the one side wall in the axial direction of the opening, and retracts form the target object when cleaning fluid is supplied into the cleaning bath to release the target object.

7. The cleaning device according to **any of the preceding claims comprising** a receiving means below the circumference of the opening on the inner surface of the one side wall, wherein the receiving member supports the target object in a point-contact state.

8. The cleaning device according to **any of the preceding claims, wherein** cleaning fluid filtered by a filter installed on the outside of the cleaning bath is circulated and supplied into the cleaning bath.

9. The cleaning device according to **any of the preceding claims comprising** a drying fluid supply bath for introducing drying fluid into the cleaning bath on the cleaning bath so as to continue therefrom.

10. The cleaning device according to Claim 9, wherein the drying fluid supply bath comprises a two-fluid nozzle to which organic solvent or inert gas at a high temperature is supplied, and the temperature of the organic solvent or the inert gas is a temperature at which the fluid can be vaporized simultaneously with injection of the fluid from the two-fluid nozzle.

11. The cleaning device according to Claim 10, wherein the organic solvent is heated by a surface heat generating member wrapped around a pipe to be connected to the two-fluid nozzle.

12. The cleaning device according to **any of claims 9 to 11, wherein** vapor of the organic solvent is used first and then heated inert gas is used as the drying fluid.

13. A cleaning method comprising:
a target object carrying step for carrying a target object into a cleaning bath, and mounting the target object to the cleaning bath with a front face thereof exposed into the cleaning bath and a rear face thereof exposed to the outside of the cleaning bath respectively while providing a clearance between the target object and the cleaning bath; and
a cleaning/rinsing step for flowing the cleaning fluid in the cleaning bath, thereby cleaning or rinsing the front face of the target object that comes into contact with the cleaning fluid by the cleaning fluid, and cleaning or rinsing a rear face of the target object by the cleaning fluid flowing through the clearance by the action of the pressure of the cleaning fluid in the cleaning bath.

14. The cleaning method according to Claim 13 including a drying step for drying the target object by introducing a drying fluid in a state in which the target object is mounted in the cleaning bath after having finished the cleaning/rinsing step.

15. The cleaning method according to Claim 13 **or 14**, the cleaning/rinsing step includes performing cleaning by using ultrasonic waves from an ultrasonic vibrating device arranged so as to oppose to and in parallel with the target object mounted to the cleaning bath.

16. The cleaning method according to Claim 14 **or 15**, wherein the drying step including using vapor of the organic solvent first and then using heated inert gas as the drying fluid in the drying step.

17. A cleaning device for cleaning or rinsing a target object disposed in a cleaning bath by cleaning fluid in the cleaning bath comprising:
one side wall that configures the cleaning bath by being in abutment with a device body and is formed with an opening corresponding to a contour of the target object;
a holding unit being capable of holding a rear face of the target object carried into the inner side of the one side wall through the opening from the outside of the one side wall and holding the target object in a vertically upright position;
**characterized in that** the holding unit hold the rear face of the target object in a non-contact state by the action of a negative pressure generated by a whirling flow.

18. A drying device for drying a target object disposed in a drying bath by drying fluid in the drying bath comprising:
one side wall that configures the cleaning bath by being in abutment with a device body and is formed with an opening corresponding to a contour of the target object;
a holding unit being capable of holding a rear face of the target object carried into the inner side of the one side wall through the opening from the outside of the one side wall and holding the target object in a vertically upright position; and
clearance defining members provided on a circumference of the opening on an inner surface of the one side wall for defining a clearance between the target object and the circumference of the opening by being in contact with the rear face of the target object.

19. The drying device according to Claim 18, wherein the drying bath comprises a drying fluid supply bath for introducing the drying fluid into the drying bath.

20. The drying device according to Claim 18 **or 19**, wherein organic solvent mist is used first and then heated inert gas is used as the drying fluid.

21. A cleaning device for cleaning a target object disposed in the cleaning bath by cleaning liquid in the cleaning bath comprising:
one side wall that configures the cleaning bath by being in abutment with a device body and is formed with an opening corresponding to a contour of the target object,
**characterized in that** the target object is oriented in a vertically upright position, the opening is closed by the peripheral edge of a surface opposite from a target surface being in tight contact with the circumference of the opening on the inner surface of the one side wall, and the target object is mounted to the cleaning bath with the target surface thereof exposed into the cleaning bath and the surface opposite from the target surface thereof exposed to the outside of the cleaning bath respectively.

22. A cleaning device for cleaning a target object disposed in a cleaning bath by cleaning liquid in the cleaning bath comprising: one side wall that configures the cleaning bath by being in abutment with a device body and is formed with an opening corresponding to a contour of the target object; and
a holding unit for holding a surface of the target object opposite from a target surface through the opening from the outside of the one side wall and holding the target object through the opening,
**characterized in that** the target object is oriented in a vertically upright position, the opening is closed by the peripheral edge of a surface opposite from a target surface being in tight contact with the circumference of the opening on the inner surface of the one side wall, and the target object is mounted to the cleaning bath with the target surface thereof being exposed into the cleaning bath and the surface opposite from the target surface thereof being exposed to the outside of the cleaning bath respectively by the holding unit.

23. The cleaning device according to Claim 21 **or 22**, wherein cleaning liquid filtered by a filter arranged on the outside of the cleaning bath is circulated and supplied to the cleaning bath.

24. The cleaning device according to Claim 21 **or 22**, including an ultrasonic vibration device arranged so as to oppose to and in parallel with the target object.

25. The cleaning device according to Claim 21 **or 22**, wherein the one side wall is configured to be movable in an axial direction of the opening with respect to the device body, the target object is carried in and held by the holding means when the one side wall moves apart from the device body, and the cleaning bath is configured by abutment between the one side wall and the device body.

26. The cleaning device according to Claim **21 or** 22, wherein the holding means hold the rear face of the target object in a non-contact state by the action of a negative pressure generated by a whirling flow.

27. The cleaning device according to Claim 21 **or 22**, wherein a drying fluid supply bath for introducing drying fluid into the cleaning bath is provided on the cleaning bath so as to continue therefrom.

28. The cleaning device according to Claim 27, wherein the drying fluid supply bath includes a two-fluid nozzle for supplying organic solvent and inert gas at a high temperature, and the temperature of the organic solvent and the inert gas is a temperature at which the fluid can be vaporized simultaneously with injection of the fluid from the two-fluid nozzle.

29. The cleaning device according to Claim 28, wherein the organic solvent is heated by a surface heat generating member wrapped around a pipe continued from the two-fluid nozzle.

30. The cleaning device according to Claim 29, wherein vapor of the organic solvent is used first and then heated inert gas is used as the drying fluid.

31. A cleaning method comprising:
a target object carrying step for carrying a target object into a cleaning bath and mounting the target object in the cleaning bath with a target surface thereof exposed in the cleaning bath and a surface opposite from the target surface thereof exposed to the outside of the cleaning bath; and
a cleaning step for flowing the cleaning liquid in the cleaning bath and cleaning the target surface of the target object that comes in contact with the cleaning liquid.

32. The cleaning method according to Claim 31 further comprising a drying step for drying the target object by introducing the drying fluid into the cleaning bath in a state in which the target object is mounted in the cleaning bath after having finished the cleaning method.

33. The cleaning method according to **any of claims 31 to 32, wherein** the cleaning step comprises circulating the cleaning liquid between the filter installed outside of the cleaning bath and the cleaning bath.

34. The cleaning method according to **any of claims 31 to 33, wherein** cleaning is performed by using ultrasonic waves from a ultrasonic vibration device arranged so as to oppose to and in parallel with the target object.

35. The cleaning method according to **any of claims 31 to 34, wherein** vapor of the organic solvent is used first and then heated inert gas is used as the drying fluid.
